(19) Europäisches Patentamt / European Patent Office / Office européen des brevets

(11) **EP 3 290 869 B1**

(12) **EUROPEAN PATENT SPECIFICATION**

(45) Date of publication and mention
of the grant of the patent:
**30.09.2020 Bulletin 2020/40**

(51) Int Cl.:
*G01D 4/00* (2006.01)   *G06F 17/40* (2006.01)
*G06Q 30/04* (2012.01)   *G06Q 50/06* (2012.01)

(21) Application number: **17187780.6**

(22) Date of filing: **24.08.2017**

(54) **A UTILITY CONSUMPTION SIGNAL PROCESSING SYSTEM AND A METHOD OF PROCESSING A UTILITY CONSUMPTION SIGNAL**

STROMVERBRAUCHSSIGNALVERARBEITUNGSSYSTEM UND VERFAHREN ZUR VERARBEITUNG EINER STROMVERBRAUCHSSIGNALS

SYSTÈME DE TRAITEMENT DE SIGNAL DE CONSOMMATION D'ÉNERGIE PUBLIQUE ET PROCÉDÉ DE TRAITEMENT D'UN SIGNAL DE CONSOMMATION D'ÉNERGIE PUBLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2016 GB 201614757**

(43) Date of publication of application:
**07.03.2018 Bulletin 2018/10**

(73) Proprietor: **Green Running Limited
Bath BA1 1UD (GB)**

(72) Inventors:
• **DAVIES, Peter**
  **Bath, Somerset, BA1 1UD (GB)**
• **DENNIS, Jon**
  **Bath, Somerset, BA1 1UD (GB)**
• **WARD, Lionel**
  **Bath, Somerset, BA1 1UD (GB)**
• **COX, Jack**
  **Bath, Somerset, BA1 1UD (GB)**

(74) Representative: **Algemeen Octrooi- en Merkenbureau B.V.
P.O. Box 645
5600 AP Eindhoven (NL)**

(56) References cited:
EP-A1- 2 748 562        WO-A2-2013/145778
US-A1- 2010 305 889     US-A1- 2011 144 819
US-A1- 2011 251 807

**Description**

FIELD

The present invention relates to a utility consumption signal processing system and a method of processing a utility consumption signal.

BACKGROUND

An aggregate utility consumption signal may be measured for a unit such as a residential or commercial building. An aggregate utility consumption signal comprises the total utility consumption data for the unit as a function of time. The utility may be gas, electricity or water for example.
It is desirable to determine the utility consumption for the individual utility consuming devices within the building.
WO 2013/145778 describes devices, methods, and programs for monitoring electrical devices. WO 2013/145778 describes a method for monitoring an electrical device which may include obtaining data representing a sum of electrical signals of electrical devices; processing the data with a Factorial Hidden Markov Model (FHMM) to produce an estimate of an electrical signal of a first of the electrical devices; and outputting the estimate of the electrical signal of the first electrical device.

BRIEF DESCRIPTION OF FIGURES

Systems and methods in accordance with non-limiting embodiments will now be described with reference to the accompanying figures in which:

Figures 1(a), (b) and (c) show example power disaggregation data;

Figure 2 is a schematic illustration of a system for processing a utility consumption signal, in accordance with an embodiment of the present invention;

Figure 3 shows an example of an extracted and stored first portion of the signal, which comprises a captured event caused by a clothes dryer switching on;

Figures 4(a) and (b) show events caused by the same microwave, and demonstrate the effect of using the different settle criteria for the right settle period;

Figures 5(a) and (b) show the resulting current signal and the voltage signal, and the generated plot, for a microwave switch on event and a washing machine switch on event respectively;

Figures 6(a) and (b) show images of a power scape for an event;

Figure 6(c) shows a flow chart illustrating a method of generating basis vectors and extracting weights for a training data sample;

Figure 6(d) shows a table containing an example list of common power consuming household devices, and an example of which features of the power signal may be effective in identifying the device;

Figures 7(a) and 7(b) show a flow chart illustrating an example time segmentation algorithm based on clustering;

Figure 8 shows an example real power signal for a microwave switch on event in the top panel, an example real power signal for a kettle switch on event in the middle panel, and an extracted first portion of an aggregate power signal in which both events occur in the lower portion;

Figure 9 shows a flow chart illustrating a method of processing utility consumption data in accordance with an embodiment of the present invention;

Figure 10 shows a flow chart of a method of adapting a system configured for processing utility consumption data, for example as described in relation to Figure 9;

Figure 11 shows a schematic illustration of the stored model and information inputted for the method described in relation to Figure 9;

Figures 12(a) and 12(b) are schematic illustrations of example house state models.

STATEMENTS OF INVENTION

According to an aspect of the present invention, there is provided a method of processing utility consumption data as recited in claim 10.

In an embodiment, obtaining the list of possible device state changes and corresponding event probability values for a first portion of a utility consumption signal comprising a change in magnitude of the signal comprises:

monitoring an input utility consumption signal for a change in magnitude;
if a change is detected:

extracting a first portion of the input signal including the change;
extracting a first set of features corresponding to the first portion;
determining an event probability value for each of one or more utility consuming device state changes, the or each event probability value being determined from the first set of features and being the probability that the first portion of the signal corresponds to the change in state of the device

In an embodiment, obtaining the list of possible device state changes and corresponding event probability values for a first portion of a utility consumption signal further comprises:
if none of the event probability values are above a first threshold value;

searching for two or more plateaus in the first portion, wherein each pair of adjacent plateaus define a further change in magnitude of the signal between the plateaus;
if two or more plateaus are detected:

extracting a sub-portion of the signal corresponding to each of the further changes and each combination of the further changes;
extracting a second set of features corresponding to each sub-portion;
determining an event probability value for each of one or more utility consuming device state changes, the or each event probability value being determined from the second set of features and being the probability that the sub-portion of the signal corresponds to the change in state of the device.

In an embodiment, the list of possible device state changes comprises combinations of device state changes.
Any device state changes corresponding to an event probability value below a fifth threshold value may be excluded from the obtained list.
In an embodiment, the method further comprises:

for each of the one or more existing house state models, determining a survival probability value corresponding to each device which is in an active state, wherein the survival probability value is the probability that the device remains in the state given the state duration; and
determining a house state survival probability value from the survival probability values corresponding to the devices in an active state;
if the house state survival probability value is below a sixth threshold value, excluding the existing house state model.

The house state survival probability value may be a normalised value. The survival probability values may be generated from stored probability distributions.
In an embodiment, house state models are only generated for time locations corresponding to the change in magnitude of the signal.
In an embodiment, the allowed changes in state are determined according to a stored set of rules and a stored model of the available devices and corresponding device states. In an embodiment, a number of devices are modelled as having three possible states: off, work, rest. In an embodiment, other devices are modelled as comprising two or more independent utility consuming elements, each having two states: on and off.
The stored set of rules may comprise one or more of the following: only house state models having a total signal magnitude less than the current total signal value of the utility signal may be generated; the only device state changes allowed are those expected to create power observations of the same sign and/or approximate magnitude as that observed, according to the stored model; The only state changes allowed are those expected to create power observations of the same approximate magnitude as that observed; the only state changes allowed are those into a different state to the existing state.

Updating one or more existing house state models to reflect each allowed change in state of one or more of the devices comprises updating the state of the device which changed state and the state duration of all of the devices.

In an embodiment, each house state model comprises a stored total house state model probability. It may also comprise information regarding the most likely state history and associated probability. Information regarding the most likely state history may comprise information indicating the previous existing house state model and transition from the previous existing house state model to the house state model corresponding to the highest house state probability value.

In an embodiment, generating one or more house state models comprises determining whether there is already a house state model comprising the same device states and device state durations, and if so, updating the total house state model probability for the house state model with the new house state model probability.

In an embodiment, the new house state model probability is compared with the associated probability of the most likely state history. If the new value is higher, the associated probability is updated to the new value.

The house state probability value may also be calculated from one or more of a signal difference probability value, which is the probability that the size of the change in magnitude of the utility consumption signal was caused by the device;; and a prior probability value, which is the relative probability of the device transition;, wherein the signal difference probability value, , and prior probability value are stored values or are generated from stored probability distributions.

In an embodiment, the method further comprises calculating the total signal magnitude of each house state model and if the total magnitude is larger than the utility signal, excluding the house state model.

In an embodiment, the method further comprises excluding any house state models having a house state model probability value below a seventh threshold value. Alternatively, the method may comprises calculating the number of house state models and if the number of house state models is larger than an eighth threshold value, excluding a fixed number of the house state models having the lowest house state model probability values for example.

In an embodiment, the stored values and models are updated based on data entered by the user and/or further inputted data through an internet connection for example and/or the input utility consumption signal.

In an embodiment, the method further comprises outputting the most probable state of each device corresponding to the first portion of the utility consumption signal.

According to a further aspect of the present invention, there is provided a utility consumption data processing system as recited in claim 1.

According to an aspect of the present invention, there is provided a carrier medium comprising computer readable code configured to cause a computer to perform any of the methods described above.

Since some methods in accordance with embodiments can be implemented by software, some embodiments encompass computer code provided to a general purpose computer on any suitable carrier medium. The carrier medium can comprise any storage medium such as a floppy disk, a CD ROM, a magnetic device or a programmable memory device, or any transient medium such as any signal e.g. an electrical, optical or microwave signal. The carrier medium may comprise a non-transitory computer readable storage medium.

In an embodiment, the system is an IoT device.

DETAILED DESCRIPTION

Systems and methods that monitor the consumption of utilities for a unit include, for example, smart meters. A unit may be a residential or commercial building for example. Smart meters may comprise real-time or near real-time sensors, utility outage notification means, and means for utility quality monitoring for a unit such as a building. The meter can monitor and record utility consumption, for example gas, electricity or water consumption for the building. The information may then be transferred to a supplier through a suitable communication medium, on request or on a predefined schedule for example. The infrastructure which may be used to facilitate collection of a utility consumption signal may include the hardware comprised in the actual smart meter, software such as data management software, communication means and customer associated systems for example.

Whilst a smart meter provides the information regarding the utility consumption for the entire unit, e.g. the entire building, it is often desirable to determine the utility consumption for the individual utility consuming devices within the building.

US9250101, the contents of which are incorporated herein by reference, describes a method for monitoring the electrical power consumption of an electrical device from an aggregate power signal for a building. The method identifies the power consumption of the particular electrical device from the signal using a power load signature unique to that device. The method aims to separate the power consumption for each device from the aggregate signal. This is referred to as disaggregation.

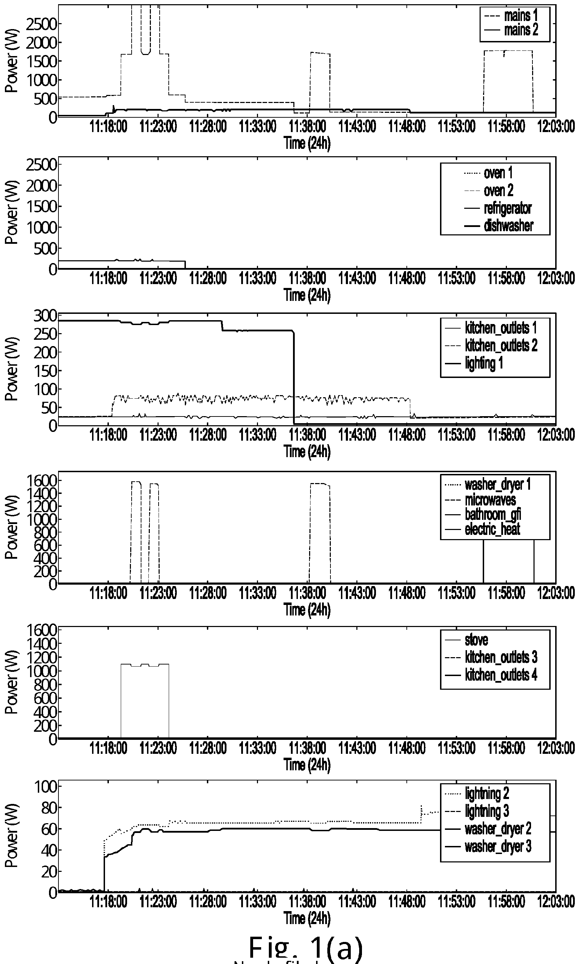

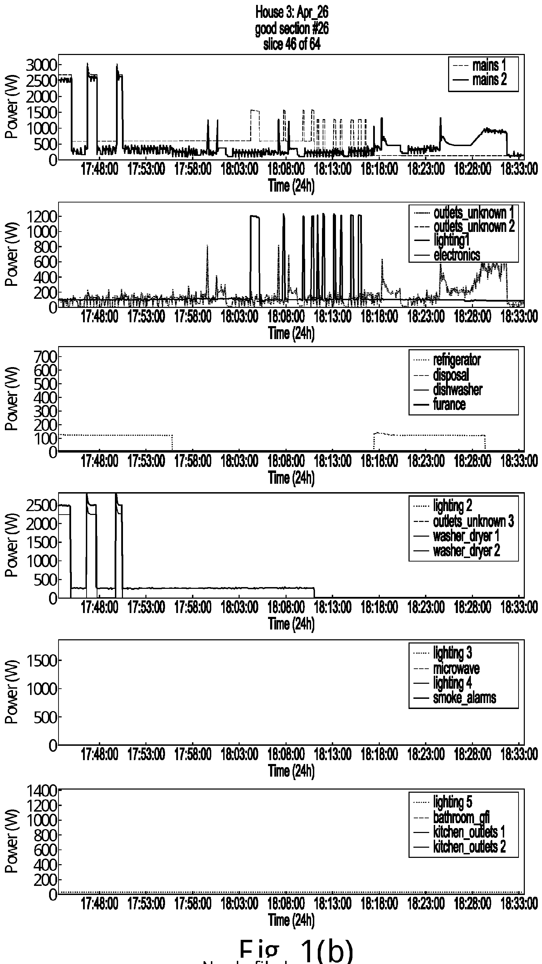

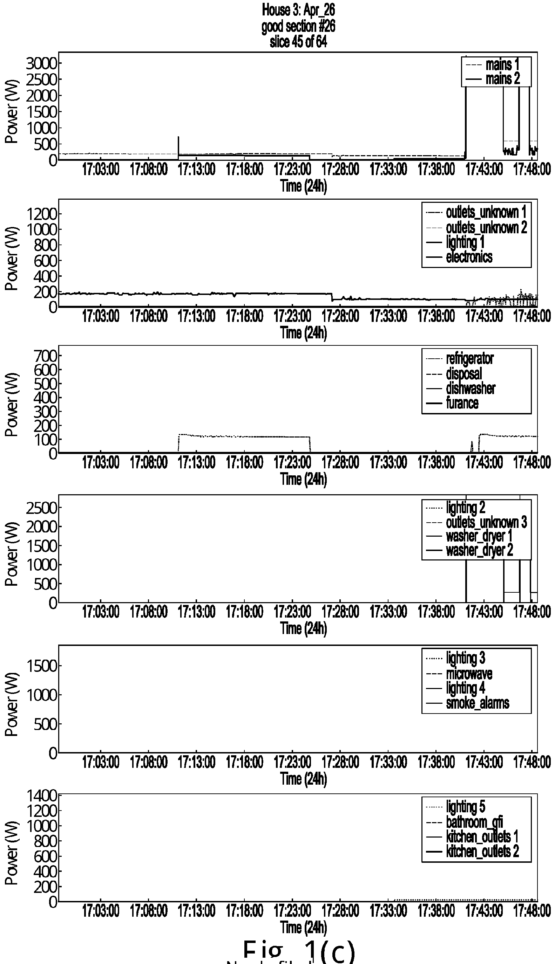

Figures 1(a), (b) and (c) show example data plotted from the REDD dataset, a publicly available power disaggregation dataset released by MIT. The data shows the real aggregate power input and ideal disaggregation output from a public dataset. The top panel shows the mains power level aggregate data, the remaining panels show sub-metered power data for each individual device in the home. In this case there are two aggregated 'mains' channels in the figure rather than one, since the data comes from a US home, where two 115V mains lines are present. In the UK a single 230V mains line is present from which all devices draw their power.

A disaggregation method may monitor electrical power consumption for the building by sampling voltage and current at high frequency (v(t) and i(t) respectively). The instantaneous power may be calculated from p(t) = v(t)i(t). The method may focus on discrete switching events for devices which step between different states. Many devices just have two states, ON and OFF, however several important devices have multiple states as described later. Several devices also exhibit transient events, which comprise an initial power increase followed by a return to a lower steady state.

Classifying switching and/or transient events in a high frequency power signal can be impeded when two or more separate devices switch on or off within a short time period of each other, for example within seconds of each other, since the power traces of both devices may occur within the duration of a single event detection of a disaggregation system, or may in fact overlap.

The former is referred to as a near-simultaneous event, i.e. where the transient power signatures associated with the two or more devices switching between states occur within a single event detection window, but have more than a small number of steady state mains cycles between them. For example, more than a small number of mains cycles could be more than 4 mains cycles, and a steady state could be a real power level that does not vary by more than 50W over that period.

The latter is referred to as a simultaneous event, i.e. in which the transient overlapped without any steady period in between.

The duration of a switching event may be as little as 1 mains cycle (20ms with 50Hz and 16.67ms with 60Hz mains power). However, it may be much longer. Microwave switch-on events may require about 3-4 seconds for the device to transition from an off state to a stable on state for example. Many washing machine motor revving events go from steady state to steady state over the course of 5-10 seconds for example. As this duration increases, the duration of the event detection window must be increased, and thus the number of near simultaneous events increases.

According to an embodiment, there is provided a method of processing a utility consumption signal which improves the classification of events which occur within a short time of each other, and therefore improves the accuracy of the disaggregation.

According to one embodiment, there is provided a method of processing a utility consumption signal which separates near simultaneous events in the aggregate signal by searching for plateaus between transient sections within a portion of the signal which has been initially determined to correspond to an event. The method initially searches for a change in the aggregate signal. When such a change is found, a portion of the signal corresponding to the change is extracted, referred to as the first portion. If the first portion of the signal is not determined as corresponding to a particular device state change with a probability greater than a first threshold value, the first portion of the signal is searched for plateaus.

These plateaus, which correspond to periods of more stable utility consumption, may indicate that multiple distinct devices switched state. However, since plateaus may also occur in the on/off signatures of electrical devices with (i) discreet inbuilt power levels such as hairdryers, heaters and showers, (ii) in the switch on signatures of certain devices containing complex electronics, such as microwaves and (iii) in the signatures of certain devices with more than one active component such as washing machines and dishwashers, these near-simultaneous events are challenging to resolve. For example, it is difficult to determine whether two observed steps in the signal occurring closely together in time are caused by a single device with a two-step on/off signature, or two independent devices, each with a one-step signature. This is especially the case when operating without specific information about the devices present in building and their particular on/off signatures for example. Inaccurate resolution of such events, such as mistaking a two-step event as being a change in state of a single device when in fact two one-step devices changed state, may lead to failed disaggregation of both one or multiple devices that changed state during the time period.

The method of processing the utility consumption signal according to an embodiment improves the disaggregation of appliance power consumption by finding and processing plateaus observed within each detected event and identifying the underlying devices.

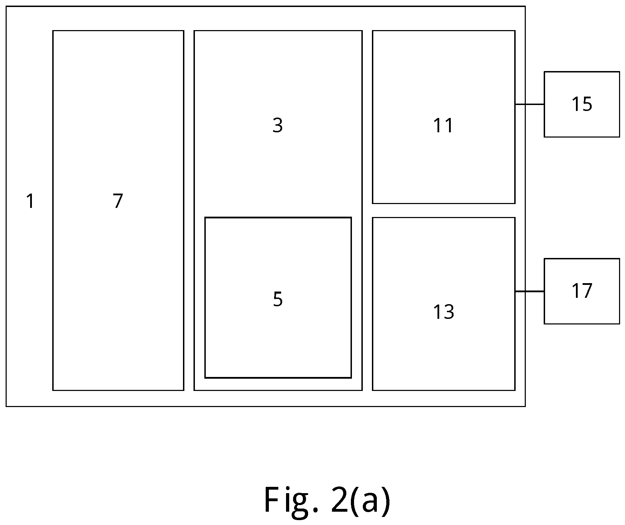

Figure 2(a) is a schematic illustration of a system for processing a utility consumption signal 1, in accordance with an embodiment of the present invention.

The system 1 comprises a processor 3 which takes an input utility consumption signal or input utility consumption data and outputs disaggregation information. A computer program 5 is stored in non-volatile memory. The non-volatile memory is accessed by the processor and the stored code is retrieved and executed by the processor 3. The storage 7 stores data that is used by the program 5.

The system 1 further comprises an input module 11 and an output module 13. The input module 11 is connected to an input 15 for receiving the utility consumption signal. The input 15 may be a receiver for receiving data from an external storage medium or a network. Alternatively, the input 15 may comprise hardware for sampling the voltage and current consumption of the unit, for example as described in US9250101. The input 15 may include an additional current input for one or more of a solar PV installation and/or a home battery storage unit.
Connected to the output module 13 is output 17. The output 17 may be an interface that displays data to the user, for example a screen. Alternatively, the output may be a transmitter for transmitting data to an external storage medium or a network.

In use, the system 1 receives a utility consumption signal or data through data input 15. The program 5, executed on processor 3, outputs disaggregation information through the output 17 in the manner which will be described with reference to the following figures.

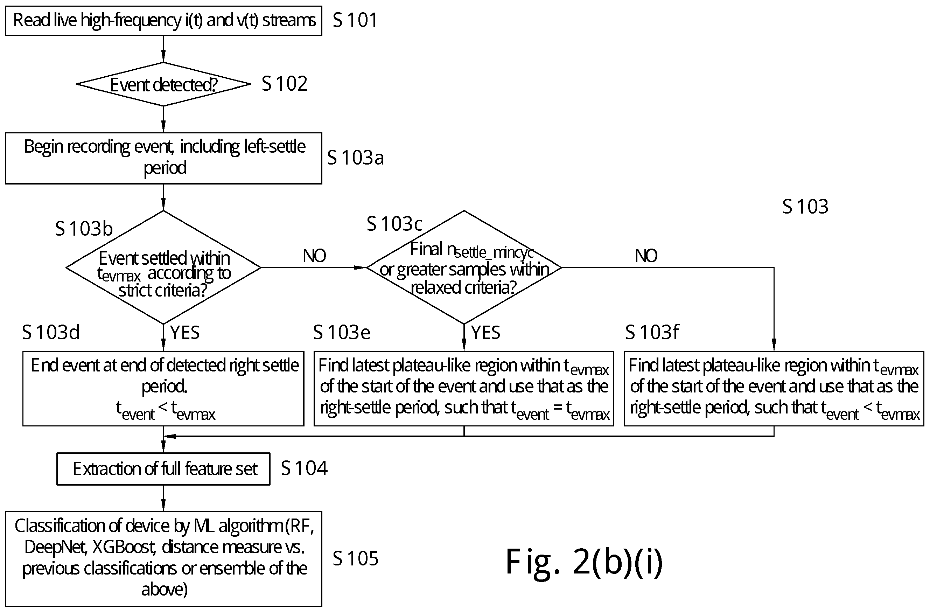

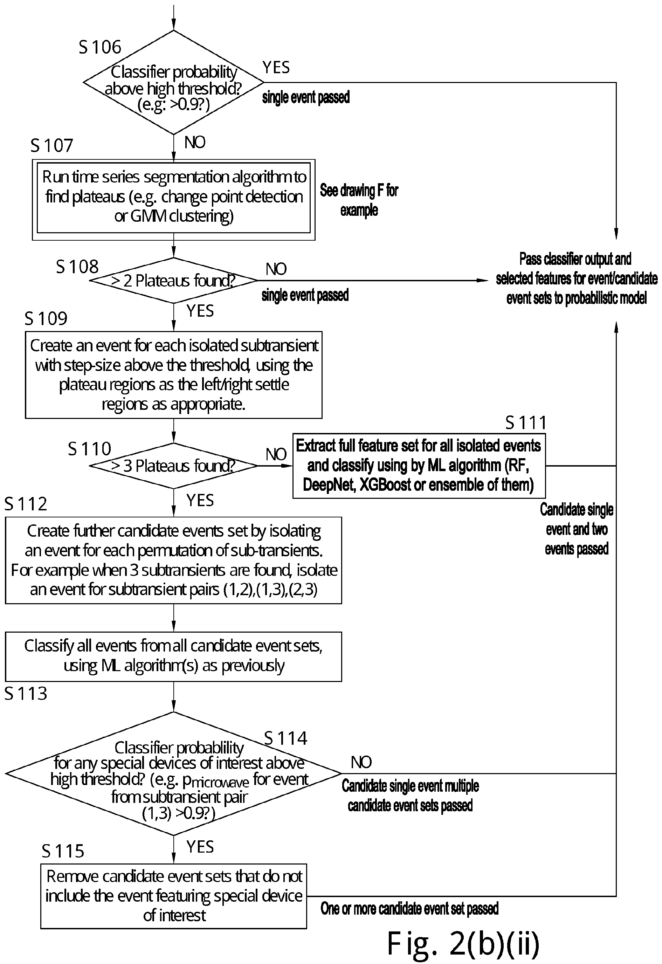

Figure 2(b)(i) and 2(b)(ii) show a flow chart illustrating a method of processing a utility consumption signal in accordance with an embodiment. The method is described in relation to processing an electrical power consumption signal, however, in alternative embodiments, the signal may relate to an alternative utility, for example water or gas.

In S101, an input utility consumption signal is received. In this case the input signal comprises an input current signal $i(t)$ and an input voltage signal $v(t)$. The voltage and current signal comprise the data generated by sampling the current and voltage for the building at high frequency. The current and voltage signal may be input in real-time. In an embodiment, an electrical power consumption signal is generated from the input current and voltage signal, by multiplying the current and voltage values at each discrete time location. The electrical power consumption signal, input current signal $i(t)$ and input voltage signal $v(t)$ are the input utility consumption signal in this case.

In an embodiment, the utility consumption signal comprises a split phase electrical signal, comprising two current signals and two voltage signals, or a three phase electrical signal, comprising three current signals and three voltage signals. In this embodiment, the electrical power consumption signal, input current signal $i(t)$ and input voltage signal $v(t)$ for each pair are the input utility consumption signal.

The electricity consumption data may be acquired from a collection apparatus such as described in US9250101 or a smart meter for example. In an embodiment, sampling is performed at a rate sufficient for sub-mains cycle features to be extracted. In an embodiment, sampling is performed at greater than or equal to 1kHz. This results in 20 samples per mains cycle. In general, sampling at higher frequencies allows resolution of finer features.

In an embodiment in which the input includes an additional current input for a solar PV installation and/or a home battery storage unit, the activity of the solar PV and home battery storage are removed from the input utility consumption signal at this stage. Thus the signal from the additional current input is removed from sampled current consumption of the unit. Solar PV and home battery storage are very noisy, but can be removed by the addition of an extra current clamp to each device, allowing the signal specific to these devices to be measured, and the measured signal to be removed from the sampled current for the whole house. The utility consumption signal processed in the following steps in this case is the sampled current for the whole house, minus the current of any home battery storage power unit, minus the current of any solar PV unit.

Processed information which displays the amount of energy generated from any solar PV installation and the charging/discharging of any home batter unit present, as well as the economic and carbon savings of both of these may also be generated from the additional current input and output to the front end app for example.

In step S102, the input signal is monitored for a change in the magnitude.

Power measurements may be used in this initial event detection phase, in which the goal is to detect appliance state changes corresponding to on/off state switches or transient phenomena such as compressors or motors initialising. Thus the input current and voltage signals are converted into an electrical power consumption signal in S101, and this signal monitored for a change in the magnitude. In an embodiment, the signal is monitored in real time.

In an embodiment, the high frequency (e.g. 100kHz) electrical power consumption data is first processed into a cycle-by-cycle power signature, comprised of one real, reactive and apparent power measurement per mains cycle. In an embodiment, only the real power measurements are used for the initial detection phase of S102. This can provide increased computational speed. Thus the signal monitored in S102 comprises a time series of real power values, with one real power value per mains cycle. In an alternative embodiment, only the apparent power measurements are used for the initial detection phase of S102. Alternatively, the real and apparent power signals are each monitored separately.

In an embodiment, S102 detects changes of the order of several hundreds of watts or larger happening over a timescale of up to several seconds. Such changes in power consumption in the home are almost certainly caused by some kind of appliance state changes corresponding to on/off transients. A very rare exception to this could be caused by a large voltage surge / collapse for example. During quiet periods, such as when occupants are out or asleep, the only state changes observed larger than 200W may be the refrigerator starting or ending its cycle. Conversely, during busy periods when occupants are using various devices for cooking and the washing machine/dryer/dishwasher is on, there may be hundreds of events in an hour, including simultaneous or near-simultaneous events.

In an embodiment, in S102, a change in the aggregate power signal is detected by calculating the difference between adjacent power samples in the real power time series signal or the apparent power time series signal. This difference is referred to as the deltapower. When the deltapower value exceeds a threshold value, referred to as the second threshold value, an event is detected. Alternatively, an event may be detected only if the sum of the deltapower values within a specified time window exceeds the second threshold value. In an embodiment, the second threshold value is 300W. In an embodiment, the time window is 600ms.

When an event is detected, the method proceeds to step S103, in which a first portion of the power time series signal comprising the detected change in magnitude is extracted and stored. In an embodiment, as well as the power time series, the portion of the current signal and the portion of the voltage signal corresponding to the first portion (i.e. for the same time period) are also extracted and stored as part of the first portion.

In an embodiment, the utility consumption signal comprises a split phase electrical signal, comprising two current signals and two voltage signals, with voltage phases differing by one half of a cycle. This is the case for a residential power signal in the US for example. In an embodiment, the utility consumption signal comprises a three phase electrical signal, comprising three current signals and three voltage signals. This may be the case for commercial buildings for example. Monitoring for a change in the magnitude of the input signal may comprise generating one or more of the corresponding real, apparent and reactive power signal from each pair of current and voltage signals, and monitoring each of the real and/or apparent power signals generated. A change detected in any of the signals is registered as a change. In this embodiment, the power time series, the portion of the current signal and the portion of the voltage signal for each voltage and current pair corresponding to the first portion (i.e. for the same time period) are also extracted and stored as part of the first portion.

S103 comprises S103a, "Begin recording event including left settle period".

A portion of the signal before the detected magnitude change is extracted and stored as part of the first portion. The duration of this portion is referred to as the left-settle period $t_{settleleft}$. The portion of the signal is referred to as the left settle portion. The left settle period is an amount of time leading up to the detected change. In an embodiment, the left-settle period is of the order of 50 cycles (1 second). The left settle period may be smaller in some cases however, for example if another event had been extracted from the live data within 1 second before the currently observed transition or if the energy disaggregation system itself has just switched on.

In an embodiment, in order to extract the left settle period, the time location of the beginning of the detected magnitude change in the power signal is determined. This can be determined by calculating a rolling variance for the signal, generating a left settle period threshold value from these variance values, and identifying the location of the beginning of the detected change in the power signal as the location at which the signal crosses the left settle period threshold value. The left settle period is then extracted as the period from a fixed time before this location, up to the detected time location of the beginning of the detected change.

In an embodiment, the left settle period threshold is:

$$\sigma_{left\text{-}settle\text{-}thresh} = max(\sigma_{left\text{-}min}, \sigma_{lrolling})$$

where $\sigma_{leftt\text{-}min}$ is a constant, and in an embodiment is a constant in the region of 50W real power. $\sigma_{lrolling}$ is the rolling variance.

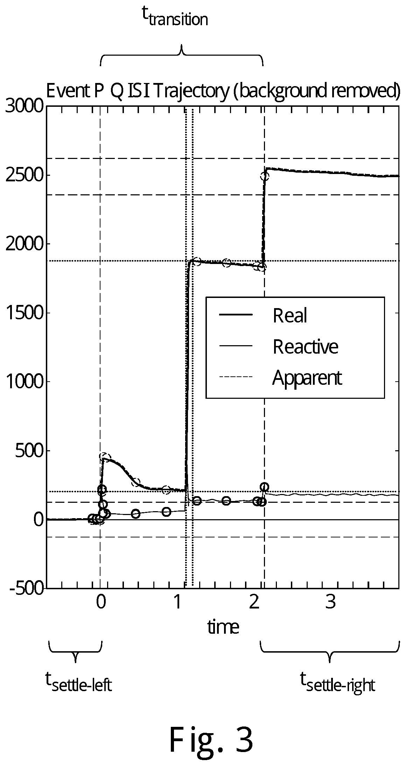

Figure 3 shows an example of an extracted and stored first portion, which comprises a captured event caused by a clothes dryer switching on, after removal of a background power level. Since the background power was fairly steady state and not noisy during this period, the resulting curves are very smooth. The plot shows the first portion, which has a duration $t_{event}$.

The dashed vertical lines in the plot show the boundaries between the left settle period $t_{settleleft}$ described above, a transition period transition and a right settle period $t_{settleright}$.

After the transition has been detected, and the left settle portion of the signal extracted and stored, the method then monitors the signal for a point at which the deltapower values are below a fourth threshold value for a set number of cycles, i.e. for a duration equal to a third threshold value. This duration is referred to as the "right settle period" and the corresponding portion of the signal the right settle portion.

It is monitored for such a right settle portion for a time $t_{evmax}$ after the beginning of the first portion. In other words, the duration of the first portion is upper bounded at $t_{evmax}$. In an embodiment, $t_{evmax}$ is 5 seconds. In another embodiment, it is 10 seconds. The inputted signal is extracted and stored until a right settle period is detected. Detection of a right settle period implies a steady state has been observed in the live real power data.

Each first portion can thus be divided into three separate phases: the left settle period $t_{settleleft}$, a transition period $t_{transition}$ and a right settle period $t_{settleright}$. The transition portion $t_{transition}$ is the part of the first portion between the left and right settle portions, in which the transition is considered to occur. It is the part of the signal from the detected magnitude change up to when the settle criteria, which is used to detect the right settle portion, has been found.

Thus $t_{event} = t_{settleleft} + t_{transition} + t_{settleright}$. This division of an event into left settle, right settle and transition periods is a reflection of the assumption that the captured events correspond to one (or more) device(s) transitioning from one steady state to another steady state.

In an embodiment, the third threshold value and fourth threshold value are constants.

In an alternative embodiment, monitoring for the right settle period comprises two stages, a first stage in which it is monitored for a right settle period according to a first settle criteria and a second stage in which it is monitored using a second settle criteria. The second stage is performed if the first stage failed to find a right settle period within the upper bound for the duration of the first portion, i.e. within $t_{evmax}$.

In this embodiment, in step S103b it is monitored for whether a right settle period occurs within $t_{evmax}$ after the beginning of the first portion according to the first settle criteria. This comprises:

a) Setting a first standard deviation threshold:

$$\sigma_{strict} = \max(\sigma_{right-min}, \sigma_{right-relative})$$

where $\sigma_{right-min}$ is a constant, and in an embodiment is a constant in the region of 50W real power. $\sigma_{right-relative} = \lambda_{lr}\sigma_{left-settle}$ when the event was an onset, i.e. a device switching into an active state, i.e. where the detected change was an increase. $\sigma_{right-relative}=(1/\lambda_{lr})\sigma_{left-settle}$ when the event was on offset, i.e. a device switching into an off state, i.e. where the detected change was a decrease. $\lambda_{lr}$ is a constant scaling factor and in an embodiment is of the order of 2, and $\sigma_{left-settle}$ is the standard deviation of the real power values in the left settle period.

In an embodiment, the values of some or all of the constants used in the method, including these constants, can be determined by an optimiser that re-runs the disaggregation method, and evaluates disaggregation performance over a range of values for the constants.

b)

It is then determined whether the real power values during an initial period of $n_{max-cyc-right}$ power cycles after the detected transition has a standard deviation equal to or less than $\sigma_{strict}$. If so, this period is designated as the right settle period. If not, it is determined whether each subsequent rolling period of the same duration has a standard deviation equal to or less than $\sigma_{strict}$. In an embodiment, $n_{max-cyc-right}$ is in the region of 25 cycles. For each subsequent rolling period, the $n_{max-cyc-right}$ cycle window is moved along e.g. 1 cycle and checked again. This is continued until either:

i) The $n_{max-cyc-right}$ window has a standard deviation less than or equal to $\sigma_{strict}$. In this case the right settle period is found and the method progresses to step S103d; or
ii) The end of the $n_{max-cyc-right}$ window reaches $t_{evmax}$, in which case the method proceeds to step S103c.

In other words, if $\sigma_{sliding} \leq \sigma_{strict}$ then the right settle period is found, where $\sigma_{sliding}$ is a vector of "sliding window" standard deviation values, and in an embodiment is calculated by taking the standard deviations of the power signal with a 200ms sliding window moving along the first portion in steps of 100ms or less.

If a right settle period is found, then in step S103d, the end of the first portion is set as the end of the right settle period. In this case, $t_{event} < t_{evmax}$.

If a settle period is not found according to the first criteria in S103b, it is searched for using the second criteria in S013c, which comprises:

a) Setting a second standard deviation threshold:

$$\sigma_{relaxed} = \lambda_{relaxed}\min(\sigma_{sliding})$$

where $\lambda_{relaxed}$ is a constant, and in an embodiment is of the order 1.25, and $\sigma_{sliding}$ is a vector of "sliding window" standard deviation values, and in an embodiment is calculated by taking the standard deviations of the power signal with a 200ms sliding window moving along the first portion in steps of 100ms or less.

b) If the real power values during the final $n_{max-cyc-right}$ cycles of the portion of the signal up to $t_{evmax}$ have a standard deviation less than or equal to $\sigma_{relaxed}$, then that period is set as the right settle period. In an embodiment, $n_{max-cyc-right}$ is in the region of 25 cycles. The method progresses to step S103e. If not, the method proceeds to step S103f.

If a right settle period is found, then in step S103e, the end of the first portion is set as the end of the right settle period. In this case, $t_{event} = t_{evmax}$.

If not, in S103f, it is searched for the longest period within the portion of the signal up to $t_{evmax}$ with standard deviation less than or equal to $\sigma_{relaxed}$ and this is used as the right settle period. The end of the first portion is set as the end of the right settle period.

The part of the data stream after the right settle period is excluded, and the first portion has been extracted and stored, corresponding to the portion from the start of the left settle period to the end of the right settle period.

The portion after the right settle period is then processed as a separate event, i.e. it is searched for a change in magnitude as in S102.

The horizontal dashed lines in Figure 3 show the trigger boundaries, or "settle criteria" for the left settle period i.e. corresponding to $\sigma_{left\text{-}settle\text{-}thresh}$ and right settle period.

During the transition period in Figure 3, i.e. the period between the left and right settle periods, there are a number of relatively flat regions Real power and apparent power are almost equal in this figure, such that the real power line is obscured behind the apparent power line.

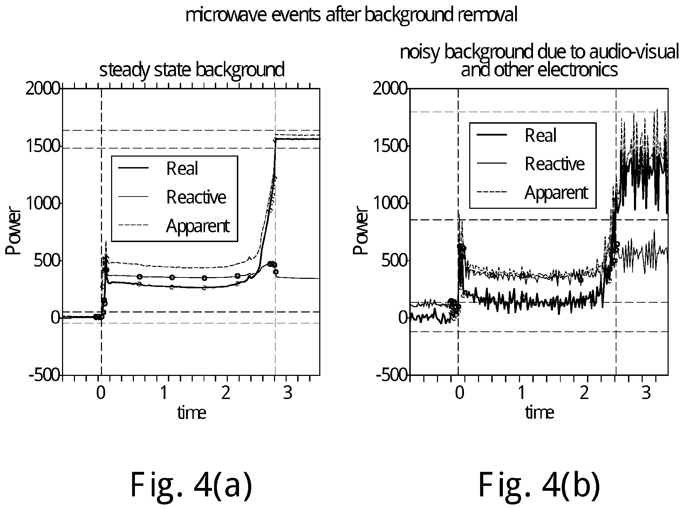

Figures 4(a) and (b) demonstrate the effect of using the different settle criteria, i.e. first or second. Both figures show events caused by the same microwave, after background removal, which in this case was done by removing the mean signal from the "off" side of the event, i.e. the mean signal of the left settle period. There is significant power use from noisy electronics / audio / visual devices in the event shown in Figure 4(b).

The bands of the right settle region in Figure 4(a) have height equal to $2\sigma_{strict}$ whereas for Figure 4(b) their height is $2\sigma_{relaxed}$. When the real power moves out of the first band the transition is considered to have begun; when it enters the second band it is considered to be finished.

Since the duration of the first portion is not fixed, capture of events from many different types of device in a household, some of which transition in ms, while others require as many as 10 seconds or more in order to finish transitioning, is possible.

Once the first portion of the input signal has been extracted and stored in S103, a first set of features is extracted from the first portion in S104, wherein the first set of features comprises one or more features of the signal. The first set of features is stored as a first feature vector of length n, where n is the number of features. Some or all of the features may be extracted from the current and voltage signals corresponding to the first portion. Some or all of the features may be extracted from changes in the phase angle of the current signal relative to the voltage signal; detected on/off transients and the frequency components in one or more of said transients; detected load measurements, RMS current signal, current signal frequency change; RMS voltage; voltage frequency change; reactive power readings and relative power readings; pattern effects of any of these measurements over time, and pattern effects across three phases.

In an embodiment, before the features are extracted, the background signal is removed. The background may be determined by generating a "mean off cycle", by generating a mean current cycle from whichever of the left settle period and the right settle period corresponds to the off state. If the detected change is an increase then the left settle period will be the off state, if it is a decrease then the right settle period is the off state. Generating a mean current cycle involves calculating the mean current value for each discrete time location in the current cycle, resulting in a mean current vector which is representative of the background. Removing the background then involves subtracting this mean current vector from the current vector of each cycle of the first portion. This equates to removing the signature of any background devices, assuming that that they are steady state.

The first feature vector may comprise one or more of the real (P), reactive (Q) and apparent power (|S|) values, IV trajectory values, FFT features or power-scape features described below. It may comprise one or more of these features processed using matrix decomposition, for example it may comprise the Fourier spectrum information processed using non-negative matrix factorisation. An optimisation algorithm implemented during the training stage, i.e. before implementation of the system, can be used to decide the best features to include in the feature set for a given training dataset. As the available training dataset grows, classifiers using more complicated models i.e. first feature vectors with a greater number of features, begin to outperform those with simpler models, so that the optimal first set of features will grow in size as the available training dataset grows. The extracted features may be grouped into subsets, where for example, the P values form one sub-set, the Q values another etc.

In an embodiment, the first feature vector comprises the cycle by cycle values of one or more of the real (P), reactive (Q) and apparent power (|S|) throughout the duration of the first portion. The raw values and/or the values with the background removed may be included. Rather than values for each cycle, a regular number of P, Q and |S| values from the left settle period, transition period and right settle period may be used, for example 5 evenly spaced samples from left settle period, 10 evenly spaced samples from transition period, and 5 evenly spaced samples from right settle period. This reduces the number of stored values in the feature vector.

The real power value of each cycle may be calculated from:

$$P_i = \frac{1}{n_{cyc}} \sum_{k=1}^{n_{cyc}} v_k(t)i_k(t), t \in T_i$$

where $n_{cyc}$ is the number of samples per mains cycle and $T_i$ is the duration of the i-th mains cycle. For a 10kHz sample rate in a country with 50Hz main power, $n_{cyc}$ = 200. $V_k(t)$ is a time series of the voltage values for the cycle k and $i_k(t)$ is a time series of the current values for the cycle k, either with or without the background removed.

The apparent power value for each cycle may be calculated from:

$$|S|_i = \frac{1}{n_{cyc}} \sqrt{\sum_{k=1}^{n_{cyc}} v_k(t)^2} \sqrt{\sum_{k=1}^{n_{cyc}} i_k(t)^2}, t \in T_i$$

The reactive power for each cycle may be calculated from:

$$Q_i = \sqrt{|S|_i^2 - P_i^2}$$

In an embodiment, the first feature vector comprises the IV trajectory values.

The cycles within the on-state (left settle period for offset events, right settle period for onset events) are considered to be the steady state high frequency signature of the device that switched state in the first portion and are used to obtain the IV trajectory features.

Extracting the IV trajectory features comprises subtracting a background from the current signal of whichever of the left settle portion and the right settle portion corresponds to the on-state, and plotting the voltage signal against the resulting current signal. Subtracting the background may be done by generating a "mean off cycle", and removing it as described above.

Each sample value resulting from this calculation is plotted on a 2D plane with current on one axis and voltage on the other. The plot resolution might be around 300 x 300 pixels for example.

The feature vector may comprise the raw pixel values of the image. Alternatively, the image is down-sampled and normalised using the following steps:

(i) normalising the current and voltage dimensions of the image by dividing them by $\max(|i(t)|)$ and $\max(|v(t)|)$ respectively. This brings all points into the range [-1,-1] to [1,1];
(ii) down-sampling the image into a 2D histogram plot, where each bucket contains the count of samples within a range of current and voltage values, for example voltage values in the range of [0.0, 0.1] and current values in the range [0.4, 0.3] would constitute one pixel of a 400 element (20x20) histogram image;
(iii) normalising each pixel value to the range [0,1] by dividing the histogram X by $\max(X)$.

The reduced number of pixel values are then stored in the first feature vector. The down-sampled values may be suitable for random forest classifiers for example. As using the raw values is higher dimension, it may be more suitable for classifiers optimised for image classification performance such as convolutional neural networks.

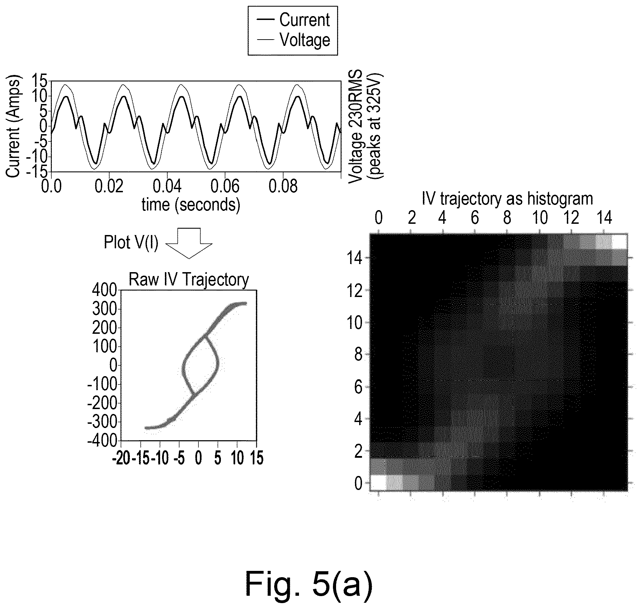

Figure 5(a) shows the resulting current signal and the voltage signal, and the generated plot, for a microwave switch on event. The resulting current signal is obtained by subtracting the stable 'off' state from the stable 'on' state, i.e. a portion of the left settle period from a portion of the right settle period if the change in magnitude is an increase or a portion of the right settle period from the left settle period if the change in magnitude is a decrease. The stable off state comes before an 'on' event and the stable on state after, whereas the stable off state comes after an 'off' event, and the stable on state before. The V(I) plot is obtained by plotting the voltage signal corresponding to the time location of the "on" state against the resulting current signal.

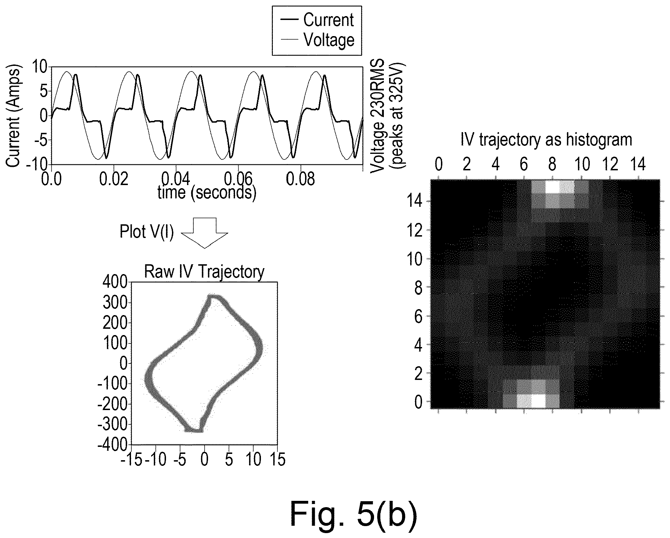

Only microwaves show the kind of 'spiral galaxy' pattern shown in Figure 5(a) when voltage is plotted as a function of the resulting current; similarly only large motors that almost exclusively are found in washing machines show the kind of 'seashell' pattern shown in Figure 5(b). While there is some variation across models for both devices, it is small, and a classifier algorithm such as a random forest or convolutional neural network can be trained on these features, by treating the extracted plots as images. The resulting trained classifier can then be used to classify inputted plots in S105.

The down-sampled and normalised histogram images are also shown in Figure 5(a) and (b). These do not correspond to the same use instance as the high resolution images, so there is a small difference in some of the axis values. The "spiralgalaxy" IV pattern is very consistent across microwave models however. Similarly, the "seashell" pattern is consistent across washing machine models. Axes labels show the (x, y) index of each pixel. The images shown are 16 x 16 and have been normalised such that the maximum bin value is equal to one.

In an embodiment, the first feature vector comprises fast Fourier transform features (FFT features). The Fourier transform may be taken for a mean power cycle for the "on" state, for the whole "on" state, or for multiple each power cycle of the "on" state separately, each with or without the background removed.

Extracting the FFT features may include generating the "mean off cycle" as described above and subtracting this mean current vector from the current vector of each of a number of cycles in the on-state, for example, i.e. the other of the right settle period and left settle period. The Fourier transform is taken from the mean of the resulting current vectors, giving the mean steady state on-cycle, or from each resulting current vector or from all the resulting current vectors together. Either or both of the magnitude and phase components of the Fourier transform(s) may stored as part of the first feature vector.

In an embodiment, the first feature vector comprises the weights of the non-negative matrix factorisation of the fast Fourier transform features (FFT features).

In this embodiment, the Fourier spectrum is processed using a matrix decomposition technique, for example non-negative matrix factorisation. The resulting values are then stored as part of the first feature vector. The current samples of the on state, with or without the background removed, are converted to the frequency domain. A mean current cycle for the on state, all of the current cycles for the on state or each current cycle for the on-state may be Fourier transformed.

The resulting frequency domain values are complex. The absolute values of these complex Fourier values are then taken. The matrix decomposition algorithm uses a stored set of non-negative basis vectors. These are generated during the training stage. A vector comprising the weights corresponding to the contribution of each basis vector to the vector of absolute Fourier values is then initialised. The initial values may be initialised to zero or to random values for example. The values of the weights are then updated, and the updated values evaluated based on, e.g. a loss function such as KL divergence. This process is iterated until convergence is reached. The resulting vector of weights is then stored as part of the first feature vector.

Although the matrix decomposition technique described is non-negative matrix decomposition, other types of matrix decomposition are possible. Furthermore, although described in relation to the Fourier spectrum of the signal, other features of the signal can be processed using matrix decomposition before being stored as part of the first feature vector, for example the apparent power values may also be processed in this manner. Processing the features using matrix decomposition compresses the features, reducing the amount of stored information. This may enable the information to be more easily transmitted for example.

In an embodiment, the first portion comprises a current signal sampled at a frequency higher than mains frequency. This high-frequency, sub-cycle waveform data comprises negative values, therefore conventionally, it would not be considered to perform non-negative matrix factorisation on these values or the complex Fourier values. Furthermore, although the absolute Fourier values are non-negative, they are not linearly additive. As the Fourier components are complex, they do not add linearly because of the way the phases interact. For this reason, conventionally it would not be considered to perform NMF on the Fourier spectrum values.

However, the inventors have found that by using the absolute Fourier values, meaningful classification results are obtained.

In an embodiment, the first feature vector comprises either or both of the magnitude and phase components of the Fourier transform of the current signal, with or without the background removed, as well as the weights extracted by processing the absolute Fourier values using matrix decomposition.

In an embodiment, the first feature vector comprises power-scape features. Power-scape features may be generated from the instantaneous real power values or apparent power values for the whole event. The power-scape features may be generated by:

    (i) Obtaining the instantaneous real power values as described above;
    (ii) Storing the values in a matrix, where each row contains the values for a single mains power cycle.

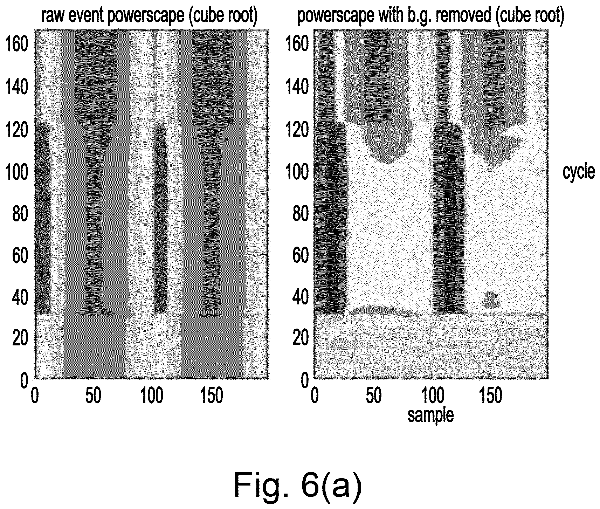

The resultant matrix can be plotted as an image, such as that shown in Figure 6(a) for example. Although the image is provided to illustrate the values, only the matrix is stored as part of the first feature set, and an image is not generated.

Generating the power scape features may also include removing the background by finding the mean off cycle and removing it as described above. The power-scape may comprise two channels, one with the raw values that were obtained, one with the background removed.

Generating the power scape features may also include applying either logarithmic or cube-root scaling, for example to emphasise the effect of smaller features.

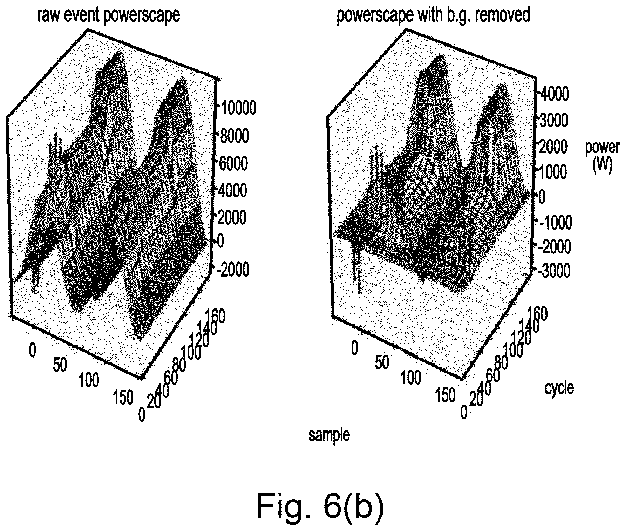

Figures 6(a) and (b) show images of the power scape for the same event, pre- and post-background removal (left and right respectively). Figure 6(a) shows a 2D heatmap and Figure 6(b) a 3D contour plot.

Some or all of these features may be extracted by first removing a background signal, which is generated from the off-state. The "off-state" is taken to be whichever of the left settle portion and the right settle portion which has a lower power value, and the on-state is taken to be the other of the left settle portion and the right settle portion, i.e. having the higher power. Thus when the first portion transitions from a lower power level left settle period to a higher power level right settle period, this is an "on event" and is either caused by a two state device stepping from off to on, or a multistate device going from some lower power level to some higher power level.

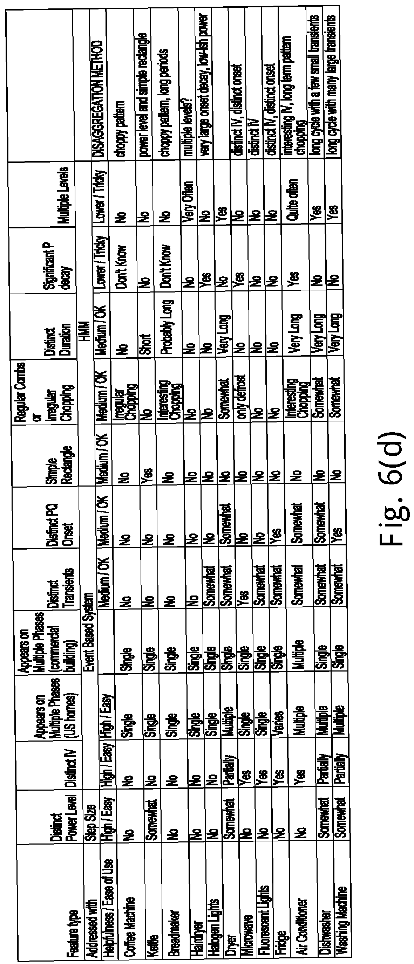

Figure 6(d) shows a table containing an example list of common power consuming household devices, and an example of which features of the power signal may be effective in identifying the device.

S105 outputs information identifying the most probable utility consuming device class corresponding to the first set of features extracted from the first portion, and a corresponding event probability value. The event probability value is the probability that the first portion of the signal corresponds to a change in state of the device. In an embodiment, S105 outputs the event probability value corresponding to each utility consuming device class and sub-class, for an inputted first feature vector corresponding to an event. Where multiple features are extracted in S104, some or all of the features may be used in the machine learning algorithm to generate the corresponding event probability values, i.e. some or all of the features may be included in the first feature vector inputted into the classifier in S105. In an embodiment, an initial processing step is performed to remove any features from the extracted feature set that are determined to be uninformative according to stored criteria.

The classifier may be based on a Random Forest classifier, the DeepNet algorithm, XGBoost algorithm, distance measure vs. previous classification or an ensemble of approaches for example. The classifier may be the Scikit Learn (Sklearn) python package Random Forest implementation for example.

The classifier is trained before implementation. This training may be performed offline, for example on a separate machine, and the trained classifier preloaded onto the energy disaggregation system.

The training is performed using a stored training data set, which comprises many example signals, e.g. current and voltage signals, each corresponding to an event. For each event in the training set, training involves extracting the first set of features, which is a feature vector $x_i$ of length n, for example comprising one or more of the features described above in relation to S104, and a ground truth identity $y_i$ which describes which class or sub-class this event is. The ground truth identity may be entered manually for example, or in a semi-automated manner. This results in a training data matrix X, where each row is a feature and where column is a training data sample, and is labelled with the type of device state change, i.e. the ground truth identity that it corresponds to.

In general, the class is the name of a utility consuming device (e.g. vacuum cleaner) which changes state.

There may be superclasses, such as "Heating Device". The classifier may not discriminate well between heating devices. This is because other than having tendencies towards a certain power level (e.g. kettles are around 3000W), their P, Q, |S| features resemble an otherwise featureless plain step, and their IV trajectory image is a flat diagonal line. As such, in an embodiment, in the training data set the following list of devices are labelled or re-labelled as a single "Heating Device" superclass. The list of heating devices in the super class may include one or more of: "Breadmaker, Coffee Machine, Dishwasher*, Haircurler*, Hairdryer*, Hairstraighteners*, Heater, Hob, Iron, Kettle, Oven, Rice Cooker, Shower, Slowcooker, Toaster, Washing Machine*". Items marked * may be included as they are known to produce plain step events either for some relatively cheaper models (hairdryers etc.) or because they contain a heating element which sometimes creates events separate from the motor / spray arm etc. In the second case, this heating element when transitioning alone will have a signature indistinguishable from other heating devices when viewed only as a -5 second event.

The trained classifier may therefore trained on a set of classes such as: {Heating Device, Microwave, Vacuum, Halogen Lights, Washing Machine Motor, Dishwasher Spray Arm, Dryer}. Events labelled as "Heating Device" are considered semi-identified, and further processing can be performed to identify these devices, for example by taking into account duration and switching information.

There may also be subclasses of multi-state devices such as "Washing Machine Motor". Such devices are capable of more than one type of state change. Event probability values are generated corresponding to each sub-class by the classifier in step S105.

The classes and sub-classes correspond to device state changes.

In an embodiment, there are considered to be three types of device, with different types of power time series:

a) Many appliances can be modelled as being "on-off" devices which are in either of the states {off, on}. One such device is a kettle. The energy consumption pattern may be modelled as turning on to a certain power level where consumption is dominated by a single electrical element (e.g. a heating element for heating devices or the motor of a vacuum clear) for a certain amount of time, before returning to being off. Device classes corresponding to these types of devices have no sub-classes, thus the device class corresponds to the device state change between on and off.

b) A number of devices can be modelled as "off-work-rest" devices, where there are three possible states: {off, work, rest}. Devices which can be modelled like this include electric hobs, ovens and heaters. These devices have dials or knobs with analogue or discrete power levels. These devices actually have a heating element that has constant power consumption, however intermediate levels of heating are achieved by turning the heating element on and off in a periodic way. The heating element being on corresponds to the device being in the "work state"; when the device is on but the heating element is off in order to moderate the heating level it is in the "rest state". Device classes corresponding to these types of devices have no sub-classes, thus the device class corresponds to the device state change between work and rest/off. The reason that the 'rest' → 'off' transition is not included as a sub-class is that there is no observation that would indicate when this is the case, i.e. if the user switches the device off whilst it was in the 'rest' state nothing would be seen in the power signal, because its power consumption is close to zero whilst resting. Therefore when occurs, the classifier will instead conclude that the device transitioned from 'work' → 'off', which will still give an accurate solution for energy disaggregation.

c) Some other more complex devices such as washing machines and dishwashers can be approximately modelled as comprising two or more independent elements that have their own binary on/off states. Device classes corresponding to these types of devices have multiple sub-classes.

The first set of features may be extracted from each of the training data samples in the same way as they are extracted from the first portion, i.e. as described in relation to S104 above. In some cases, extracting the features from the training data samples may comprise further steps.

For example, where the first set of features comprises a vector comprising the weights corresponding to the contribution of each of a plurality of basis vectors to feature values extracted from the signal (for example a Fourier spectrum or apparent power values), the basis vectors must first be determined in the training stage. The weights may then be extracted for each training sample, using the basis vectors.

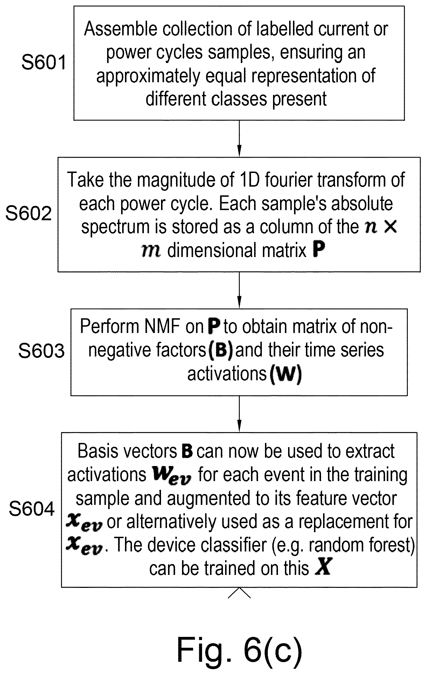

Figure 6(c) shows a flow chart illustrating a method of generating the basis vectors and extracting the weights for each training data sample according to an embodiment. The method is described in relation to non-negative matrix decomposition, however other types of matrix decomposition are possible. Furthermore, although described in relation to the Fourier spectrum of the signal, other features of the signal can be processed using matrix decomposition before being stored as part of the first feature vector.

Furthermore, although here the use of matrix decomposition to process features extracted from a portion of the utility consumption signal corresponding to a change in magnitude of the utility consumption signal, in fact this method can be used on features extracted from any portion of the signal.

Prior to extracting the first feature set comprising the weights for each training data sample, a set of non-negative basis vectors must be learned. This may be done by running an non-negative matrix factorisation (NMF) algorithm on a selection of training data.

In S601, the training data used to generate the basis vectors may be selected from the full training data set. For example, the selection may comprise a number of events, e.g. 100, from each device class (or subclass) that is used in the device classifier. The events may be processed to remove the background signal. Additionally, further devices which do not correspond to device classes or sub-classes may be added to the selected training set. S601 may comprise assembling a collection of labelled current or power cycle samples from the full training data set.

Before running the NMF algorithm, the training samples are converted to the frequency domain in S602. The frequency domain values are complex. The absolute values of these complex Fourier values are taken for each training sample. By taking the magnitudes of each value in the complex spectrum, it is ensured that all values are non-negative. In this step, the magnitude of the 1D Fourier transform of each or all power cycles in the on state, or of the mean power cycle of the on state, with or without the background removed, is taken for each selected training data sample.

Each sample's absolute Fourier spectrum is stored as a column of an nxm dimensional matrix P, where the columns are labelled with the device class or sub-class of the sample. Each column of P, i.e. $p_1$, ..., $p_m$, is a training data sample of length n, comprising the absolute values of the Fourier spectrum and labelled with the device state change.

The stored absolute values are those on which the NMF algorithm is performed. In S603, the NMF algorithm generates a set of non-negative basis vectors using the selected training data, which are decompositions of the absolute values of the Fourier spectrums stored in the matrix P. These basis vectors are generated by Non-negative Matrix Factorisation (NMF), which uses an algorithm to decompose a non-negative matrix P of dimension $n \times m$ (n rows by m columns) into the product of two non-negative matrices B and W, which respectively have dimension $n \times r$ and $r \times m$

(again, rows and columns), where typically r < n.

Thus B comprises r columns, each of which is a basis vector. Each one of these basis vectors may be considered to correspond to a latent aspect of the power or current cycles upon which the NMF algorithm is run. The basis vectors thus correspond to latent structure in the data, leading to improved classifier performance.

W has m columns, each of which contains the weights used to form a reconstruction $\tilde{p}_i$ of the training samples $p_i$ as a linear combination of the basis vectors of B. The "training sample $p_i$" refers in this case to the absolute values of the Fourier spectrum for the sample, which can then be reconstructed from a linear combination of the basis vectors using the weights.

Obtaining the basis vectors B and weights W comprises a random initialisation of the B and W matrices, followed by iteratively updating one matrix and then the other, for example by the following update rules:

$$B_{\alpha\mu} \leftarrow B_{\alpha\mu} \frac{\sum_i W_{i\alpha} P_{i\mu}/(WB)_{i\mu}}{\sum_k W_{k\alpha}}$$

$$W_{i\alpha} \leftarrow W_{i\alpha} \frac{\sum_\mu B_{\alpha\mu} P_{i\mu}/(WB)_{i\mu}}{\sum_\nu B_{\alpha\nu}}$$

Each updated B and W value is used to generate the reconstructed training sample $\tilde{p}$, and this is compared to the original training sample $p_i$ using the KL divergence. Other loss functions can be used to evaluate the updated values however. The B and W values are iteratively updated to optimise the KL divergence.

The matrix of bases B and matrix of weights W are thus determined using an NMF solver algorithm, for example an algorithm within the Expectation Maximisation (EM) family of algorithms, and either (i) optimise a loss function, e.g. the Euclidean distance of the reconstruction error, i.e. $\| \tilde{P} - P\|^2$ or the KL divergence between each sample. The KL divergence is:

$$D(P||\tilde{P}) = \sum_{ij} \left( P_{ij} \log \frac{P_{ij}}{\tilde{P}_{ij}} - P_{ij} + \tilde{P}_{ij} \right)$$

The algorithm is mathematically proven to converge to a locally optimal solution, and as such once the algorithm converges (as defined by magnitudes of the change in values between iterations falling below a threshold vlaue) the algorithm is stopped and the result, i.e. B and W, is output.

The basis vectors B are thus obtained in S603.

In S604, the weights are then extracted for each event in the entire training data set, using the basis vectors B obtained in S603. Feature values are extracted for each event in the training set, e.g. the Fourier transform values, and these are transformed into a basis vector representation using the NMF algorithm and the stored basis vectors B. For each event, a vector comprising the weights corresponding to contribution of each basis vector to the extracted feature values is initialised. The initial values may be initialised to zero or random values for example. The values of W are then updated and the updated values evaluated based on, e.g. a loss function, for example KL divergence. This is iterated until convergence is reached. The resulting vector of weights are then stored as part of the first feature vector. In this case, the basis vectors B found in S603 are used, so B is not iterated. Only the weights are iterated.

The weights are extracted in this step in the same way as they are extracted in S104, from the first portion.

These weights are added to the first feature vector for each training event, or replace the first feature vector for each training event, i.e. by adding or replacing the input for each row in the training data matrix X for the column corresponding to that event.

Thus the first feature vector for each training event may comprise the weights of the basis vectors for the steady state change associated with the mean current cycle of the on-state with the background removed, the weights of the basis vectors for the entire event or both of the above.

The training data matrix X comprising the first feature vectors is inputted into a training algorithm for the classifier prior to implementation, (where each row is a feature and where each column is a feature vector $x_i$ corresponding to each training data sample).

During implementation, after a first portion has been extracted from the live feed, the first set of features are extracted as described in S104 above. The output is feature vector $x_{new}$, which contains the same features as the training data matrix.

The pre-trained classifier is then used to predict $\tilde{y}_{new}$, which is the set of event probability values for each of the device classes and sub-classes. The event probability value is the probability that the device class or sub-class is responsible for the feature vector corresponding to the first portion, where the sum of $\tilde{y}_{new}$ over all the device classes is equal to 1. The output $\tilde{y}_{new}$ is a list of the probabilities corresponding to each device class and sub-class.

In an embodiment, the utility consumption signal comprises a split phase electrical signal, comprising two current signals and two voltage signals, with voltage phases differing by one half of a cycle or a three phase electrical signal, comprising three current signals and three voltage signals, as described above.

In this case, whether a power level change is detected in the power signal corresponding to one phase or in the power signals for multiple phases may indicate the type of device. For example, nearly all smaller devices such as kettles, microwaves or vacuum cleaners are likely to draw power from a single phase only. Meanwhile the heating elements of white goods are likely to draw power from both of the split phases in a US home, as would the power supplies of HVAC systems in commercial buildings.

In one embodiment, the method comprises separating the events into events observed on one phase only, and events observed on multiple phases, before step S104 or before S105. If the events are separated before step S104, different features may be extracted for the events observed on one phase only, and events observed on multiple phases. Alternatively, the same features can be extracted in both cases. For the single phase signal, the features are extracted in the same manner as described above in relation to S104, for the phase in which the event was observed only. For the multiple phase signal, the set of extracted features comprises the features for each phase, and these are all included in the feature vector. Thus in an embodiment, where the event is detected on a single phase only, the feature vector has a standard length with one set of features, and where the event is detected on two or three phases, the feature vector is double or triple the length of the standard feature vector.

Two separate device classifiers, one which classifies events observed only on single phases, the other which classifies events that simultaneously appeared on multiple phases can then be used in S105. The single phase device classifier and the multiple phase classifier may have different classes, and be trained on data corresponding to different types of devices. For example, the single phase classifier for a US house may not need to be trained on any large white goods such as dishwashers or washing machines. Similarly, the multiple phase device classifier may not be training on any microwaves, toasters, hairdryers or vacuum cleaners for example. The multiple phase device classifier may have around two-thirds of the total device classes for example, whereas the single phase classifier has one third. Thus the events are "filtered" before classification is performed into single phase and multiple phase, and each classifier has only classes relating to the devices relevant for single phase and multiple phase respectively, and is only trained on data relating to these devices.

The single phase classifier may be a standard classifier. The arrangement of the phases is arbitrary and depends on how the device is connected, e.g. the split phase from which the smaller components (like a fan) draw power could be either way around. For example, Figure 1(b) and 1(c) show aggregate mains power and disaggregated power data for a US home in which a washer dryer draws power from both of the split phases. The heating element in the washer dryer device draws power equally from both of the split phases, but the other components in the device, primarily the motor, only draw from phase 1. In both figures, the first panel shows the aggregate mains readings and the fourth panel shows disaggregated washer-dryer power consumption, for phase 1 and phase 2. The installation of the device is arbitrary, i.e. the motor could instead have been drawing from phase 2. In order that the multi-phase classifier can classify devices installed either way, the multi-phase classifier is trained on a training set where each example is mirrored. This means that for each example in the multi-phase training data set, as well as the original signal there is generated a feature vector in which the phase interchanged. For the example described, this results in two versions of each event in the multi-phase training data set. In one version, the features extracted from phase 1 and phase 2 respectively fill the first and second half of the feature vector, i.e. the feature vector comprises the features extracted from phase 1 followed by the features extracted from phase 2. In the other version, the features are swapped, such that phase 1 fills the second half and phase 2 the first half, i.e. the feature vector comprises the features extracted from the phase 1 signal followed by the features extracted from the phase 2 signal. Where the mains signal is a three phase signal, for the multiphase classifier, where the event is observed in all three phases, a feature vector corresponding to each permutation is generated for each training example, i.e. a feature vector comprising the features of phase 1 followed by those of phase 2 followed by those of phase 3; phase 1 followed by phase 3 followed by phase 2; phase 2 followed by phase 3 followed by phase 1; phase 2 followed by phase 1 followed by phase 3; phase 3 followed by phase 2 followed by phase 1; and phase 3 followed by phase 1 followed by phase 2. Thus 6 feature vectors may generated for each example event in the training set in which the event is observed in all three phases. Training the multi-phase classifier in this way allows the classifier the flexibility to classify such devices regardless of the installation.

For devices that draw power from multiple phases, most of the time the change in power level is equal on both phases. Sometimes the draw is not quite equal however. This is because the large power consuming components such as heating elements draw from both phases, but smaller components of the device e.g. a fan or a motor may draw from a single phase. This characteristic will be contained in the features extracted in S104, such as the IV trajectories and powerscapes, which will be different for the different phases. The classifier may be trained to recognise these different features for different phases as indicating specific devices. Disaggregation of many of the devices in US homes may be performed by classifying the signals from multiple phases separately, i.e. features are extracted from each phase.

All devices are given an event probability value according to the classifier confidence output vector, which has a confidence for each class and sub-class upon which it has been trained, with all confidences summing to one.

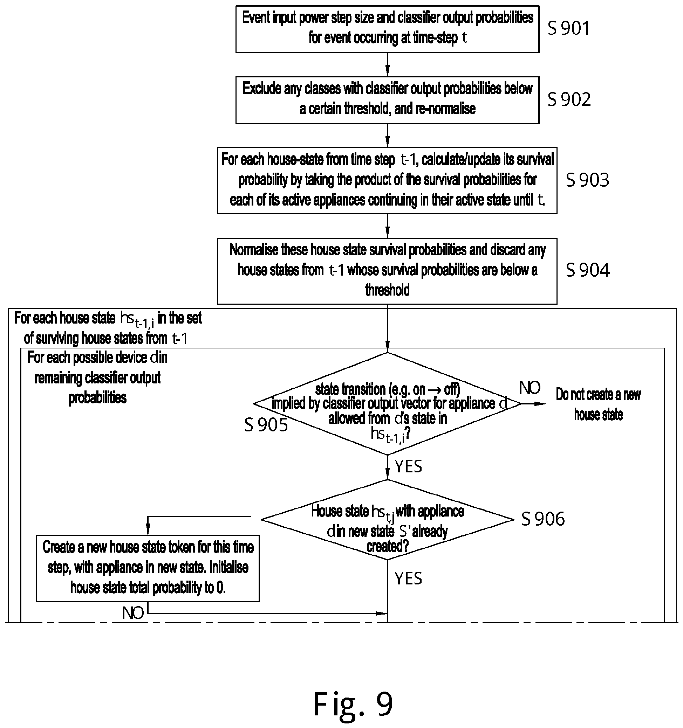

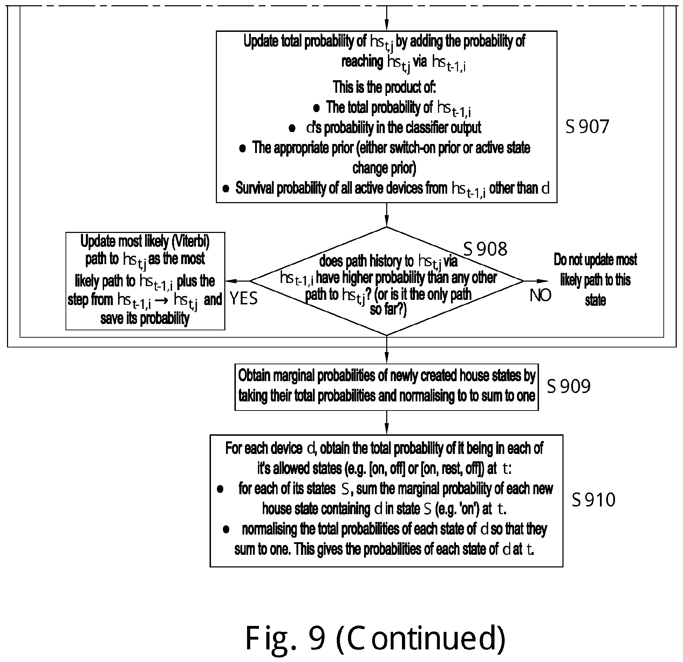

In an embodiment, the list of device state changes, which correspond to the classes and sub-classes in the classifier, and the corresponding event probability values are outputted as a final output, or are inputted into a probabilistic model for further processing, as described in relation to Figure 9 below. Alternatively, the most probable device state change corresponding to the first portion of the signal is simply outputted from the system as the final output. In these cases, steps S106 onwards described below are not performed.

In step S106, it is determined whether any of the event probability values are above a first threshold value. In an embodiment, the first threshold value is 0.9. In one embodiment, if one of the event probability values is larger than the first threshold value, the list of device state changes, which correspond to the classes and sub-classes in the classifier, and the corresponding event probability values are then inputted into a probabilistic model for further processing, as described in relation to Figure 9 below. Alternatively, the most probable device state change corresponding to the first portion of the signal is simply outputted from the system as the final output for example.

If none of the event probability values are above the first threshold value, the method proceeds to S107. In the following steps, further event analysis and possible separation into sub-events is performed.

As described above, in certain cases, two appliances may change state within the first portion, such that two steps occur. In this case, it is expected that the initial classification performed in S105 will return low event probability values, and the further processing described in the following steps is then performed to try to resolve these "sub-events".

S107 comprises searching for two or more plateaus within the first portion. In an embodiment, S107 comprises searching the transition period and the right settle period only. A time series segmentation algorithm can be run in order to find the plateaus. The time series segmentation algorithm may be a cluster algorithm based on a Gaussian Mixture Model or a change point detection algorithm for example.

This step segregates the first portion, which comprises overall on/off/transient step detections, into separate sub-steps, corresponding to sub-events. The segregation into sub-events may be performed on the power values, for example by using cycle-by-cycle real power values or high frequency power readings.

In an embodiment, the time series segregation is based on a clustering of the time series of real power values from the first portion. A clustering algorithm based on a Gaussian Mixture Model (GMM) may be used to cluster the 1D data. In an embodiment, the algorithm is run on the first portion multiple times, each time with a different number of clusters, from within a range of possible cluster number values. Each cluster which is found is expected to correspond to a meaningful fixed level that the detected step event transits through. The GMM is run multiple times with the number of clusters varied between a set range, for example 2 to 6.

Once a time series segmentation algorithm such as clustering has been performed, further steps may be performed in order to determine the most suitable model, and to merge any segments which are adjacent in time. The below described steps are described in relation to clustering, however similar steps may be performed for any time series segmentation method.

For each run, a model suitability measure such as AIC (Akaike Information Criterion) or BIC (Bayesian Information Criteria) is calculated, which scores the suitability of the model against the data, both rewarding simplicity (favouring fewer clusters) and the accuracy of the representation of the data (favouring more clusters).

The power values are then assigned to the clusters in the most suitable model, as determined by the suitability measure.

The longest contiguous regions that the clustering according to this model found in the time series data are then determined. In other words, within the power values in each cluster, the longest period of points which are contiguous in time is found. This single period is output for each cluster. The other values within the cluster are excluded. A contiguous region is thus output for each cluster.

In an embodiment, if the power values contained within adjacent contiguous regions are within $2\sigma$ (2 standard deviations) of each other then they are considered to overlap and merged.

The returned set of contiguous regions is considered to be the set of plateaus.

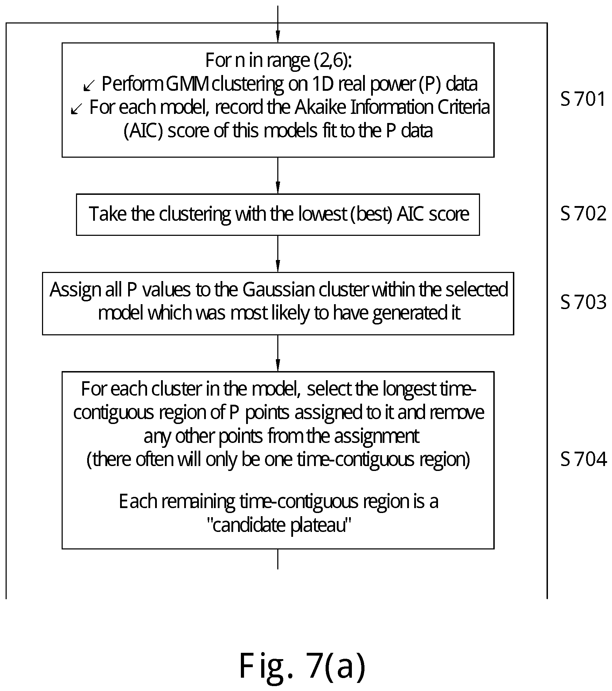

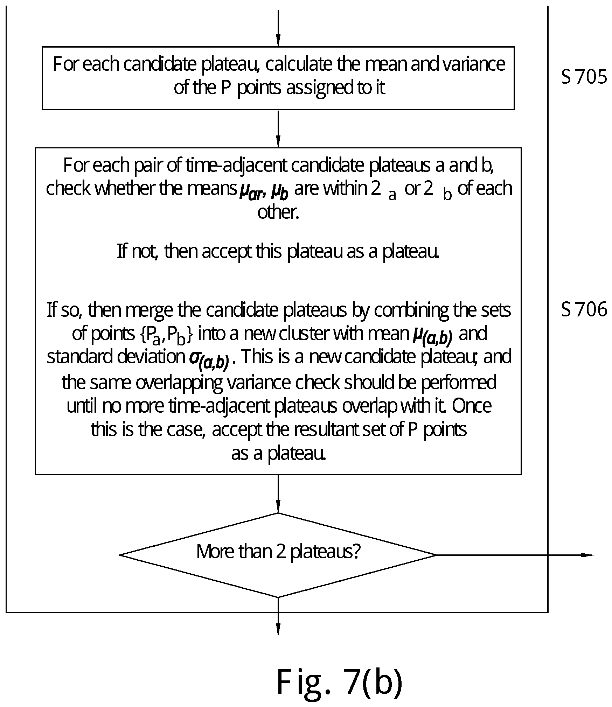

Figures 7(a) and 7(b) show a flow chart illustrating an example time segmentation algorithm based on clustering. The first portion of the signal is inputted. In step S701, a GMM based clustering algorithm is run on the time series of the real power values multiple times, with the number of clusters varied between 2 and 6. Each run returns a model locating the clusters. For each model, a fitness score, i.e. a measure of suitability, is generated to give the suitability of the model to the data, for example an AIC score.

In S702, the model with the lowest AIC score is determined. In S703, the power values are segregated into the clusters of the model with the lowest AIC score. In S704, for each cluster in this model, the longest time contiguous region of power values is found, and all other power values excluded from the cluster. The remaining power values make up the plateau.

In an embodiment, further processing is performed to improve the accuracy of the method. This further processing may be performed for any type of time series segmentation algorithm, i.e. not simply clustering. In step S705, the mean and variance of the power values for each plateau are determined, and in S706 it is determined whether, for each time adjacent plateau, the mean power values are within 2 standard deviations of the first plateau or 2 standard deviations of the second plateau of each other. If not, then the plateau is accepted, and if so then the two plateaus are combined, and the process repeated for the new time adjacent plateaus, using the mean and standard deviation of the new, merged plateau.

A Gaussian Mixture Model algorithm such as Python's Scikit Learn package may be used.

Alternative methods of segregating the first portion of the signal into plateaus can be used, for example change point detection. As for the clustering method, the input to the change point detection algorithm may be the time series real power readings from the first portion. Change point detection is an algorithm which finds changes in a time series reading.

The output from S107 comprises a start and end time for each plateau found.

In an embodiment, where the utility consumption signal comprises a split phase electrical signal, or three phase electrical signal, the corresponding real or apparent power signal from each pair of current and voltage signals is searched for two or more plateaus.

In S108, it is determined whether two or more plateaus were detected. If not, the list of device state changes, which correspond to the classes and sub-classes in the classifier, and the corresponding event probability values found in S106 are then inputted into a probabilistic model for further processing, as described in relation to Figure 9 below, or are outputted as the final output.

If more than two plateaus are found, the method progresses to S109.

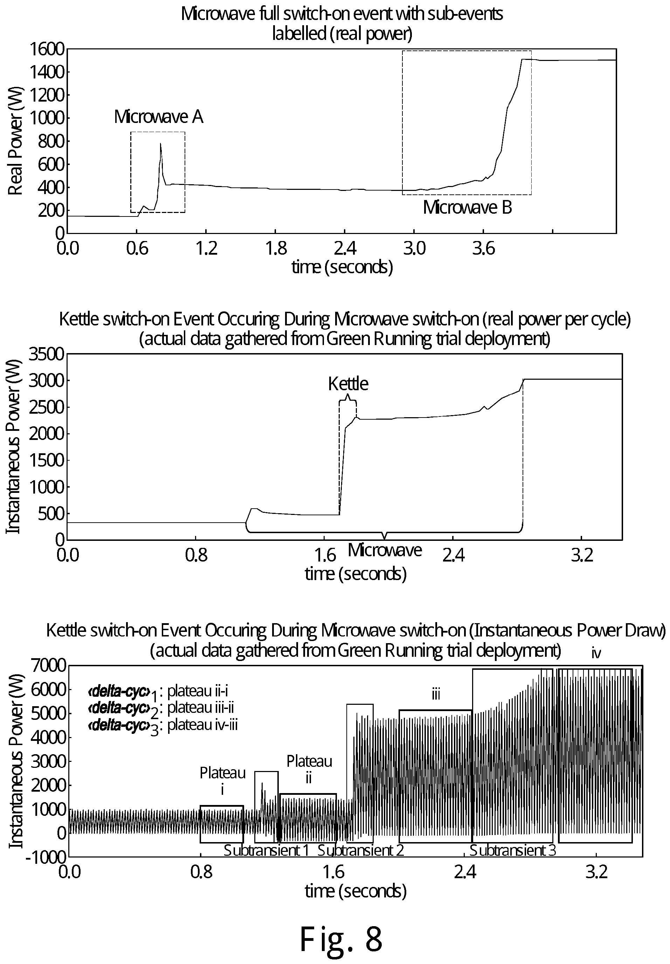

Figure 8 shows an example real power signal for a microwave switch on event in the top panel, an example real power signal for a kettle switch on event in the middle panel, and an extracted first portion of an aggregate power signal in which both events occur in the lower portion. Four plateaus have been found in the first portion, in time order, plateau i located in the left settle portion, plateau ii and iii located in the transition period and plateau iv located in the right settle portion.

A sub-transient corresponds to the transition period which separates a pair of adjacent plateaus in the extracted first portion of the signal. The number of sub-transients is:

$$n_{subtransients} = n_{plateaus} - 1$$

Thus each pair of adjacent plateaus define a further change in magnitude of the signal between the plateaus, referred to here as a sub-transient. Figure 8 thus shows a first portion of the signal corresponding to an event containing 4 plateaus and therefore 3 sub-transients. Sub-transient 1 is between plateaus i and ii, sub-transient 2 is between plateaus ii and iii and sub-transient 3 is between plateaus iii and iv.

In the following steps S109 to S112, all of the possible sub-portions of the signal, given n sub-transients in the first portion of the signal are extracted. Thus a sub-portion of the signal is extracted corresponding to each of the further changes and each combination of the further changes (i.e. each sub-transient and each combination of sub-transients). This corresponds to all possible events formed from k sub-transients, where $0 > k > n$. The case k=n is simply the original event extracted in S104 and classified in S105. Thus extracting a sub-portion of the signal corresponding to each of the further changes and each combination of the further changes comprises extracting a sub-portion of the signal corresponding to each of the further changes and each combination of the further changes other than the combination of all of the further changes, since this is not a sub-portion of the signal, but corresponds to the original first portion. The k=0 case is obviously meaningless.

Therefore in S109 and S112, a total of $2^n-2$ possible sub-portions are extracted, where the number of extracted sub-portions is:

$$\sum_{i=1}^{n-1} {}^n C_i = \sum_{i=0}^{n} {}^n C_i - {}^n C_0 - {}^n C_n$$

$$= \sum_{i=0}^{n} {}^n C_i - 1 - 1 = 2^n - 2$$

For the case where there are 3 sub-transients, the number of events to examine is therefore ${}^3C_1 + {}^3C_2 = 3 + 3 = 6$. For an event with 4 sub-transients there are ${}^4C_1 + {}^4C_2 + {}^4C_3 = 4 + 6 + 4 = 14$ candidate subevents to extract.

The number of events to be extracted rises exponentially with n. However, in many power signals it is rare to observe 3 or 4 sub-transients, and more is very unlikely. A case where 4 sub-transients might occur in an event could be where a kettle switches on or off during a dryer's switch on (as in Figure 3, with an additional 3000W step at some point in the event).

In S109, a sub-portion is extracted- for each adjacent pair of plateaus. Thus a sub-portion of the signal comprising each adjacent pair of plateaus and the sub-transient between the plateaus, is extracted and stored as a sub-event. For the first portion of the signal shown in Figure 8, this corresponds to extracting and storing a sub-portion from the beginning of plateau i to the end of plateau ii (i-ii); a sub-portion from the beginning of plateau ii to the end of plateau iii (ii-iii); and a sub-portion from the beginning of plateau iii to the end of plateau iv (iii-iv). This corresponds to extracting a portion of the signal corresponding to each individual sub-transient. The current and voltage signals corresponding to these sub-portions may also be extracted and stored.

In S110, it is determined whether more than three plateaus were found in S107. If not, the method progresses to S111.

In S111, the same procedure as described above in relation to S104 and S105 is performed for each extracted sub-event, i.e. for each sub-portion of the signal extracted and stored in S110. The set of features may be the same or different to those extracted in S104, i.e. different features may be used for this classifier. Thus a second set of features, i.e. a second feature vector, is extracted for each sub-portion, and inputted into the classifier. For each sub-portion, the earlier plateau is treated as the left-settle portion and the later plateau is treated as the right-settle portion, and the features are extracted in the same manner as described above and inputted into a classifier. The classifier may be the same classifier used in S105, or a different classifier, i.e. based on a different algorithm and/or trained on a different data set.

Where the plateaus appear on multiple phases, multiple phase sub-portions are extracted, i.e. the sub-portion of the power signal for each phase is extracted, the features then extracted for each phase and included in the feature vector. The sub-event is then classified by a multiple phase event classifier, which may be the same multiple phase event classifier described above in relation to S105 or a different multiple phase event classifier. When the separated plateaus appear on a single phase only, they are extracted as a single-phase sub-portion and classified by the single-phase device classifier. A whole event, i.e. the initial detected change in magnitude, may appear on both phases, however there may then be one or more separable sub-events that each appear on a single phase only, and are classified by the single phase classifier. This could occur in a US home for example, where a toaster turns on during the dryer's on-transition.

The classifier outputs, for each sub-portion, a list of device state changes, which correspond to the classes and sub-classes in the classifier, and the corresponding event probability values.

A list of device state changes, which correspond to the classes and sub-classes in the classifier, and the corresponding event probability values for each sub-portion in the combination is inputted into a probabilistic model for further processing, as described in relation to Figure 9 below, together with the list of device state changes and the corresponding event probability values found in S106. Alternatively, the most probable device state change or combination of device state changes corresponding to the first portion of the signal is simply outputted from the system as the final output for example.

If more than three plateaus were found, the method progresses to S112. In S112, further events are created for each combination of sub-transients, other than the combination of all of the sub-transients (as this has been processed in S105). This corresponds to each combination of further changes (other than the combination of all of the further changes). The sub-portion of the signal comprising each combination is extracted and stored as a sub-event. For the first portion of the signal shown in Figure 8 for example, each two adjacent plateaus has been extracted in S109, corresponding to each sub-transient. Each combination of sub-transients other than the combination of all of the sub-transients is then extracted in S112. This corresponds to extracting and storing a sub-portion: from the beginning of plateau i to the end of plateau iii (i-ii-iii), corresponding to the first and second sub-transient; from the beginning of plateau ii to the end of plateau iv (ii-iii-iv), corresponding to the second and third sub-transient; and from the beginning of plateau i to the end of plateau iv, with the contribution of the second sub-transient removed (i-ii-iv), corresponding to the first and third sub-transient. Removing the contribution of the second sub-transient comprises: taking the sub-portion of the signal from the beginning of plateau ii to the end of plateau iii, removing the background signal (i.e. by removing the mean current cycle from the lower of plateau ii and iii from the other of plateau ii and iii), and if plateau iii is higher than plateau ii, removing the resulting signal from the beginning of plateau iii onwards (i.e. plateau iii and iv), if plateau ii is higher than plateau iii removing the resulting signal from the beginning of plateau iii backwards. The current and voltage signals corresponding to these sub-portions may also be extracted and stored.

In general, where multiple sub-transients are present (i.e. more than three plateaus), if the sub-transients corresponding to the sub-portion are not adjacent (i.e. there is an intermediate sub-transient), it is necessary to remove the effect of the intermediate sub-transient(s) before extracting the features. This may be done in the same way that the background is removed. A mean delta current cycle for the intermediate sub-transient (or set of sub-transients) is calculated and this is removed from the point of the sub-transient onwards if the sub-transient was an 'on' transition, or backwards if it was an 'off' transition, as described in relation to sub-portion (i-ii-iv) in Figure 8 above, where for the candidate event comprising from sub-transient 1 and 3 in figure 8, the effect of sub-transient 2 must be removed. The mean delta cycle associated with sub-transient 2 is calculated by subtracting the mean off cycle from the mean on cycle. These are the mean cycles of plateaus ii and iii respectively. This mean delta cycle is then subtracted from each cycle from the start of sub-transient 2 onwards.

Table 1 below shows the events and sub-events from the first portion of the signal shown in Figure 8. The sub-events of the first six rows are extracted in S109 and S112, the remaining seventh row event was extracted in S104.

Table 1: events and sub-events from the first portion of the signal shown in Figure 8

| | left, right settle regions* **transient section is taken as region between end of left settle region and start of right settle region** | steady state features extracted from | Notes |
|---|---|---|---|
| (1) | plateau i, ii | $(deltacyc)_1$ | |
| (2) | plateau ii, iii | $(deltacyc)_2$ | |
| (3) | plateau iii, iv | $(deltacyc)_3$ | |
| (1,2) | plateau i, iii | $(deltacyc)_{12}$ | |
| (1,3) | plateau i, iv | $(deltacyc)_{13}$** | **subtract $(deltacyc)_2$ from each cycle from point of subtransient 2 onwards |
| (2,3) | plateau ii, iv | $(deltacyc)_{23}$ | |
| (1,2,3) (original event) | plateau i, iv | $(deltacyc)_{13}$ | (original event) - already extracted in S104 and classified in S105 |

In step S113, the same procedure as described above in relation to S104 and S105 is performed for each extracted sub-event, i.e. for each sub-portion of the signal extracted and stored in S110 and in S112. Thus a second set of features, or second feature vector is extracted for each sub-portion, and inputted into the classifier. The second set may be the same or different to the first set. The classifier outputs, for each sub-portion, a list of device state changes, which correspond to the classes in the classifier, and the corresponding event probability values. The left most plateau in the sub-portion is treated as the left settle portion and the right most plateau treated as the right settle portion.

Thus a fixed length second "feature vector" is extracted from each sub-portion, to characterise the information contained within the raw high frequency current and voltage signals. This is the same feature vector extraction process used in S104. To extract the features, the difference in the power state before and after the transition may be taken, i.e. subtracting the "offstate", which is the lowest of the left most plateau and the right most plateau, from the "onstate", which is the highest of the left most plateau and the right most plateau, in the same way as the background is removed in S104.

The same classifier used in S104 or a different classifier may be used to determine the event probability values corresponding to each device state change, i.e. each class or sub-class in the classifier. Thus for example, a new RF classifier specifically trained to recognise sub-events of different duration, that has been trained on a slightly different training dataset than the classifier used in S104 may be used. Events of duration less than, for example, 2 seconds can be classified by a classifier that has not seen any full microwave events, for example. Thus it is not necessary that this classifier be trained on longer events (full microwave events are greater than 2 seconds). The classifier may be based on algorithms such as Random Forests (RFs) and Deep Neural Networks (DNNs) or an ensemble of these, that has been trained on prior examples of such sub-events in available power consumption datasets.

The same classifier used in S104 can be alternatively be used, in which case it should also be trained on a training data set that includes the subcomponents of device onset patterns that have multiple steps, such as the MicrowaveA and MicrowaveB patterns shown in Figure 8.

A list of the device state changes and corresponding event probability values for each possible combination of sub-portions that could make up the first portion is then inputted into a probabilistic model for further processing, as described in relation to Figure 9 below, together with the list of device state changes and the corresponding event probability values found in S106. Alternatively, the most probable device state change or combination of device state changes corresponding to the first portion of the signal is simply outputted from the system as the final output. For the first portion shown in Figure 8 for example, the possible combinations of sub-portions are {(i-ii),(ii-iii),(iii-iv)} i.e. three separate device state changes, {(i-ii-iii), {iii-iv}, {i-ii-iv), (ii-iii)}, and {(i-iii-iv), (i-ii)}.

In an alternative embodiment, the method proceeds to S114 before outputting the event probability values. In S114, it is determined whether the event probability value for any sub-portion corresponding to any special devices of interest is over a threshold value. The special devices may be devices with no heating elements for example. For example, the probability of the sub-portion (1,3) being a microwave may be >0.9 leading it to be found in this step.

If no such event probability values are found, the event probability values are output, i.e. as the final output or into a probabilistic model.

If one or more event probability values are found, all of the device state combinations comprising the sub-portions corresponding to the event probability values are output, whereas the others are excluded in S115. Alternatively, the event probability values may be monitored as they are generated in S113, and further event probability values are not generated if event probability values above the threshold value are found.

In an embodiment, a further step is included, which allows merging of certain "obvious" combinations of sub-portions which are likely to have been generated by the same appliance. For example, microwave, vacuum cleaner or washing machine motor related "sub-events" have strongly identifying features and frequently can be merged at this stage.

In an embodiment, the outputted classes and corresponding event probability values for the sub-portion combinations, as determined by the classification result from the S113, are searched for a list of obvious combinations. The obvious combinations are determined according to stored criteria relating to, for example, the separating in time of the sub-events and the order of the sub-events. This initial "obvious" event detection may be followed by analysis with a classifier in order to output an event probability value corresponding to the merged microwave sub-event.

For example, microwave switch-on events comprise two distinct phases, referred to as MicrowaveA and MicrowaveB. When a microwaveA on sub-event is followed by a microwaveB on sub-event in a possible combination of sub-portions, each with a probability above a threshold value, and the sub-events are within a learned time range, for example around 2-3 seconds, these are merged into a single event, which is then classified . If the classifier classifies this combination as a microwaveon event with probability above a threshold value, the two sub-events are merged into a single sub-event, with an event probability value generated by the classifier.

Alternatively, simple logic is used, instead of using a classifier. For example, when the classifier in S112 returns an event probability value above a certain threshold for a microwaveA on event for a first sub-portion, and an event probability value above the threshold for a microwaveB on event for a second sub-portion which is 2-3 seconds after the first sub-portion, and sub-portion are part of a possible combination of sub-portions which make up the first system, the two sub-events are merged into a single sub-event, with an event probability value, generated by combining the original event probability values for example. Again, stored criteria including, for example, a threshold for the probability value, the type of device and the duration of time between the two sub-events are used to select and merge sub-events.

Alternatively, other techniques such as convolving the derivative of the signal with the derivative of known devices in the house, such as microwaves and dryers, can be used.

This newly merged sub-event may be part of one of the possible combinations of sub-events making up the first portion, each having associated device state changes with associated event probability values.

Thus in steps S107 onwards, any "sub-events" occurring within the first portion are separated and resolved separately. Some of the sub-events may subsequently be merged. In an embodiment, when two subevents are classified together in S114, they are found to be a single sub-event with a new event probability value. If this exceeds a threshold value the other candidate combinations can be excluded, in S115. If not, then the candidate combinations will remain with their respective event probability values for each sub-portion being output or passed into the probabilistic model for further processing.

Sub-events that are not merged are considered as belonging to separate appliances, and, along with any merged sub-events, are formed into combinations, and the list of combinations of device state changes and associated event probability values may then be passed to the subsequent probabilistic model described in relation to Figure 9 below for example. This model uses a separate set of decision processes that can later merge sub-events - based on their temporal (time duration) characteristics, for example if they switch off at the same time repeatedly over several occurrences of the same subevent combination.

The method shown in Figures 2(a) and (b) is a method of monitoring (i) the power consumption of an electrical device and (ii) monitoring a household of electrical devices using for example, an IoT device, where the method is based on detecting on-off switching and transient events in the aggregate power measurements, for example rapid change in power consumption, and dealing with nearsimultaneous events. The detected events are evaluated with a method which is based on the assumption that they may be caused by more than one independent device changing state. If the event cannot be classified with high probability then, where possible, the event is broken down into sub-events according to any periods of stable power consumption, for example sub-second or second-duration periods. Classifying the events and sub-events is done by extracting a pattern describing the change in power characteristics of each event or sub-event, a "feature vector" containing the power load signature unique to that device, and classification by an algorithm pre-trained against a dataset of previously gathered patterns.

In an embodiment, each outputted event or sub-event in a combination has one or more of the following set of values associated with it, in addition to the raw voltage/current and features extracted:

a. 'Timestamp' : the UTC timestamp corresponding to the start of the event or subevent
b. 'Power Before': the active power before the event occurred e.g. 132.54 (Watts)
c. 'Power After': the active power after the event occurred e.g. 2232.54 (Watts)
d. 'Power Step' : the change in active power over the period of the event or subevent e.g. 2100.0 (Watts)
e. 'Predicted Device Name': the most probable appliance name, according to the classification of the event or subevent e.g. 'Microwave'
f. 'Confidence' : the probability of the appliance in e. e.g. 0.912
g. 'Classifier Result' : the full output of the classification in the form of a table of Device State Change(s)' vs. 'event probability value'.
h. 'Mains ID' A unique identifier for the live wire carrying the event or sub-event (as some countries have more than one).

The above described method can be used to perform live disaggregation of home appliances. In an embodiment, the method can output disaggregation results within a time period of the order of several seconds. In an embodiment, there is a guaranteed response time. The method can identify which devices have changed state and display this to the user within, e.g. seconds, via a front-end application. Simple step detection may be used to find abrupt changes in the utility consumption signal, which will go on to be extracted as "events". In some cases, the abrupt change is simply in the form of a step, however in other cases the change is more complex, and may, for example, contain ramps, switchbacks and/or flat areas within the transition. A complex event such as this might (i) be caused by single individual devices such as microwaves, dryers and washing machines whose state transitions are often complicated or (ii) be caused by more than one device happening to change state within the duration that the event was recorded. This is more likely to occur as the length of the event time duration window is lengthened.

The method allows use of a long maximum duration $t_{evmax}$ for the event duration time window, i.e. the maximum length of the first portion, for example 5-10s. This allows devices that take a long time to transition to still be captured. The method can process the near-simultaneous events that will frequently also be captured due to the long window.

The output of the method can be used as a disaggregation result itself, or as an input into a higher level model such as the probabilistic model described in relation to Figure 9.

Where plateaus are detected within the transition periods of events, this implies that either a near simultaneous event has occurred and the flat part of the event is a true steady state where no devices are in the process of changing state or that a single device is in the process of a complicated switch-on pattern and the flat part of the event (the plateau) is actually a pseudo-steady state where a device is partway through changing state.

The plateaus found in S107 become the left and right settle periods for each sub-event. Finding these plateaus allows definition of the subevents and generation of the features. Initial detection of a change in magnitude of the signal may be run with an upper bound, for example 5-10 seconds, in order to capture slowly transitioning devices, such as microwaves switching on and motor containing white goods changing state. Many of these white goods transition in a way such that intermediate steady plateaus are observed. However "near simultaneous events", i.e. more than 1 device transitioning in the same 5-10 second window, may also be captured. The method aims to determine whether a plateau is an actual steady state between multiple device transitions, or an interlude between (sub)transitions of a complicated device switching. The plateaus are used as the "rightsettle" period of the preceding sub-transient and the "leftsettle" period of the following sub-transient.

Thus in Figure 8, the first sub-transient, corresponding to the "microwave A" onset pattern, is analysed by comparing plateau ii (right settle period and onstate) with plateau i (left settle period and offstate), and so on.

In general, most of the time an aggregate power signal is in a steady state.

In the above described method, an event vs. event similarity measure between the extracted pattern and a stored "pattern library" is used to determine the probability an observed pattern belongs to one of the known and previously observed appliances in the user's household or whether it belongs to an as yet unobserved class. A random forest based approach may be used for comparing event switching data for example.

In an embodiment, the method of utility consumption signal disaggregation described above outputs the most likely time series utility consumption for each device in a building given a single time series aggregate utility consumption signal for the whole building's consumption, as was shown previously in Figure 1. Using high frequency sampling it is possible to obtain some strongly identifying features for many household devices, such as those shown in Figures 5(a) and (b), and train a classification algorithm such as a random forest or a deep neural net to classify switching events from previously unseen signals using the method described in relation to Figure 2(b) for example.

The power consumption of a significant number of household devices however are dominated by a heating element which is a purely resistive load, and does not have any uniquely identifying high frequency features such as microwaves, vacuums or washing machine motors. The table shown in Figure 6(d) highlights that this. In this table, devices which are more easily classified based on higher frequency features are those with one or more green entries in the "Event Based System" columns, whereas those which are more accurately classified by including lower frequency features are those in the HMM column. Green entries indicate a very helpful feature, orange a somewhat helpful feature and red an unhelpful/missing feature. Whilst a number of the devices (bottom ⅓ rows) may be relatively easily identified using an event based approach to high speed energy monitoring such as described in relation to Figure 2(b), the devices whose energy consumption is dominated by a heating element (first ⅔ rows) are harder to classify using the method described in Figure 2(b).

However, these usage patterns have identifiable features over much longer length scales, such as the total duration that the devices are used for, and the ways that their heating elements switch on and off ('chopping') in irregular or distinctive ways (such as coffee machines) or in very structured ways ('combs'), in order to regulate temperature as is the case with Irons/Hobs/Ovens/Heaters. The method described below in relation to Figure 9 performs further classification of the events based on this information.

Thus within the aggregate signal there is information about devices at very different timescales. To achieve accurate disaggregation, it is desirable to take all information, from the high frequency features (e.g. ms and sub-ms features) up to features having a duration of the order of minutes into account. Thus in an embodiment, the method described in relation to Figure 9 below classifies the events based on longer time scale features.

Figure 9 shows a flow chart illustrating a method of processing utility consumption data in accordance with an embodiment of the present invention. The method is described in relation to processing an electrical power consumption signal, however, in alternative embodiments, the signal may relate to an alternative utility, for example water or gas.

The method may be based on a Factorial Hidden Markov Model (FHMM).

The method comprises obtaining a list of device state changes and the corresponding event probability values for a first portion of a utility consumption signal comprising a change in magnitude of the signal. In an embodiment, obtaining the list comprises receiving a utility consumption signal, monitoring for a change in the magnitude of the input signal, if a change is detected, extracting a first portion of the input signal including the change and generating a list of device state changes and the corresponding event probability values. This may be done according to the method described above in relation to steps S101 to S105 of Figures 2(b)(i) and 2(b)(ii) for example, or according to the full method described in relation to these figures in which case the list of device state changes and combinations of device state changes, and the corresponding event probability values for each device state change for the first portion are the input for this method.

The following is an example of the processing steps that take place when an event or combination of sub-events is detected and tracked by a probabilistic model.

Step S901 comprises inputting power step size and classifier output probabilities for a detected event or combination of sub-events occurring at time-step t. Time step t is taken to be a single time step corresponding to the first portion of the signal for example. Thus whereas each sub-event may occur at a different time within the first portion, when input to S901 they are treated as having occurred at the same, single time step. An event, and possibly one or more combinations of sub-events are input for the time step, with the associated parameters being (1) the power step magnitude (e.g. change in real and/or apparent power over the event), and (2) the event probability values, i.e. classifier output probabilities for each device state change. Further associated information may be inputted.

The method thus processes the utility consumption data at discrete time points, each corresponding to an event. The time points are irregular, and the method only processes data at time points at which an event has been observed. This means that long periods of repetition between sparse events contained in a household power signal are not processed, only the events themselves are processed.

For example, for the event shown in Figure 8 above, the following information may be inputted:

- change in real power, list of device state changes and corresponding event probability values for the entire first portion, {(i-ii-iii-iv)}, found in S106;
- change in real power, list of device state changes and corresponding event probability values for each of the three sub-portions {(i-ii),(ii-iii),(iii-iv)};
- change in real power, list of device state changes and corresponding event probability values for each of the two sub-portions {(i-ii-iii), {iii-iv)};
- change in real power, list of device state changes and corresponding event probability values for each of the two sub-portions {i-ii-iv), (ii-iii)};
- change in real power, list of device state changes and corresponding event probability values for each of the two sub-portions {(i-iii-iv), (i-ii)}.

The event probability values for the latter four were found in S113.

These correspond to the following arrangement of sub-transients into events:

(i) {1}, {2}, {3}
(ii) {1,2}, {3}
(iii) {1,3}, {2}
(iv) {1}, {2,3}
(v) {1,2,3}

where a pair of braces around a subset indicates a sub-event.

For n sub-transients, for the case where there is no upper limit on the number of independent devices corresponding to the observations in the first portion, the number of possible arrangements S(n) is given as follows:

$$S(n) = \sum_{i=0}^{n-1} \left\{ {}^{n-1}C_i \times S(n-1-i) \right\}$$

**with base case:** $S(0) = 1$

This number of possible arrangements rises faster than exponentially (see Table 2 below). In an embodiment, only combinations where no more than two devices were responsible for the observed n sub-transients are generated and used. In this case the number of arrangements $S_2(n)$ is:

$$S_2(n) = 2^{n-1}$$

Table 2: Number of possible arrangements of n sub-transients S(n) and number of possible arrangements when limited to two devices being responsible

| n | $S(n)$ | $S_2(n)$ |
| --- | --- | --- |
| 1 | 1 | 1 |
| 2 | 2 | 2 |
| 3 | 5 | 4 |
| 4 | 15 | 8 |
| 5 | 52 | 16 |
| 6 | 203 | 32 |

As the number of possible arrangements grows, various optimisations can be used to reduce the number of combinations. In an embodiment, a fixed number (e.g. 3) of the most probable arrangements are inputted for each time step.

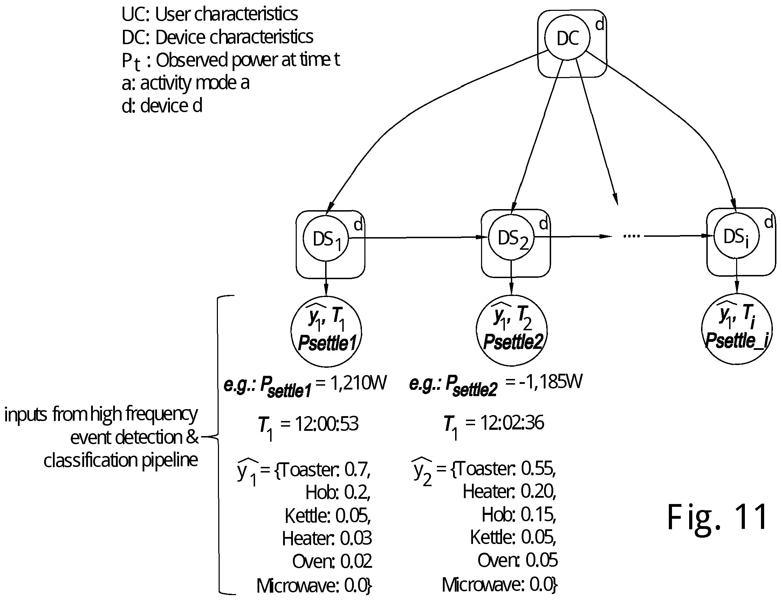

Figure 11 shows a schematic illustration of the information inputted in S901, represented in the circular boxes together with the information from the classifier described in relation to S104 and S109 above. The list of device classes and corresponding probabilities for each event or sub-event DS are inputted.

In S902, any classes or sub-classes, i.e. device state changes, with event probability values below a fifth threshold value are excluded from the input data. The remaining probability values are then re-normalised. Thus unlikely event possibilities, with probability below the fifth threshold, are excluded. In an embodiment, the probability threshold is a relative probability threshold. In an embodiment, the fifth threshold value is 20% of the highest event probability value.

Each device d in the unit is assumed to have a limited number of discrete states $m_d$. Determining the device state at time t allows disaggregation of the device.

S903 comprises, for each of one or more existing house state models, determining a survival probability value and/or a hazard rate.

A house state model comprises stored information indicating a state for each device and indicating a state duration for the device if in an active state. The existing house state models are the house state models which were generated at the previous event detection time step, i.e. at time step t-1. If no house state models were generated at a previous event detection, a single "background" house state is used as the existing house state, i.e. in which all of the devices are in the off state.

A house state can be thought of as the combined states of each device in the house. The number of possible house states is therefore $\Pi_{d\subset devices}m_d$. For example, in a house with only two devices, both of which only have two possible states (on and off) there are a total of 4 possible house states. However in a real situation, there may be in the region of 20 devices that are being kept track of, which have in the region of 2-5 modelled device states each. A stored model of the available devices and their possible states is used to generate the house state models, where the house state model comprises information indicating the state (and state duration if in an active state) of each of the available devices. The stored model thus may comprise a list of devices, e.g. dishwasher, washing machine, etc., and the possible states for these devices. For some types of devices, the stored model will have only one of the device, e.g. dishwasher. For others, e.g. hobs, the stored model will have multiple devices. The stored model may be based on use data about the actual devices in the unit for example, or based on a standard model of the typical devices. The stored model thus determines the number of possible house states, since it comprises a set number of available devices, each with a set number of possible states.

The house state survival probability value is calculated from a device state survival probability value calculated for each device which is in an active state in the existing house state model. The device state survival probability value is the probability that the device remains in the state given the state duration and the time of the new event, i.e. time step t. Thus for each house-state from time step t-1, the survival probability is calculated by taking the product of the survival probabilities for each of its active devices, i.e. the probability of the device continuing in the active state until time t. Alternatively, or additionally a hazard rate value may be generated and used instead of the survival probability value.

Thus in this step, for each existing House State $hs_{t-1,i}$ in the model's previous time step t-1, the method calculates/updates the combined survival probability of the active appliance's states. For house states in which more than one device is in an active state, the total survival probability is the product of each individual device's survival probability.

A duration based switching probability model generated prior to implementation using the hazard rate (also known as Force of Mortality) from survival analysis may be used to determine the survival probability for each device state.

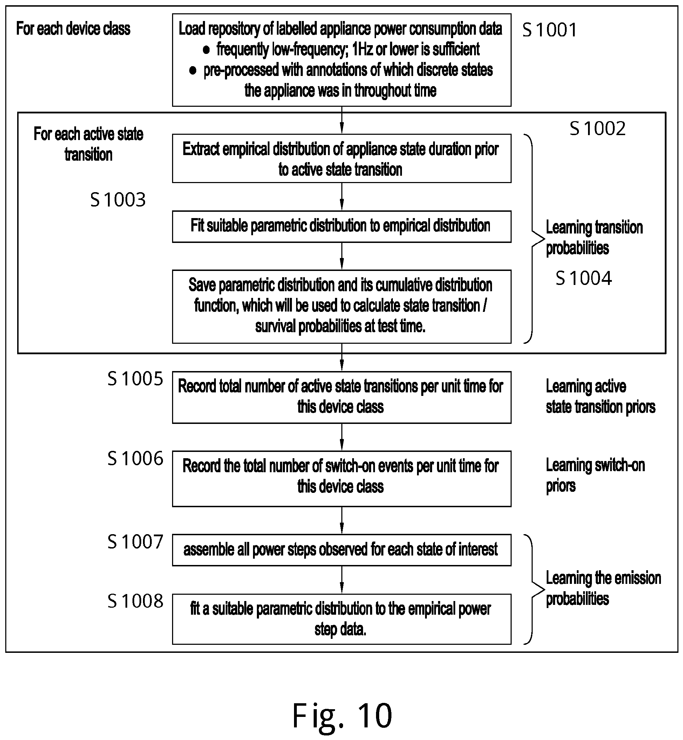

Prior to implementation, a transition probability model is generated for each device active state and stored in the system. This model comprises the variation of the probability that the device transitions from the active state into another state with the duration of time since the device transitioned into the active state. The model may comprise a transition probability value for each discrete time duration value. Details of how the model may be generated are given in relation to Figure 10 below, which relates to the training stage.

In an embodiment, in S903, for each device in an active state in each existing house state model, the transition probability at the time t is determined from the stored model. The duration is calculated from the time t and the state duration for the device in the existing house state model, by taking the state duration and adding the time between time step t-1 and time step t. The survival probability is calculated from the transition probability. The survival probability is simply the probability that none of the transitions took place, i.e. one minus the probability of transition given the current active state duration. The house state survival probability value is calculated by taking the product of each of the device state survival probability values for the house state.

For example, if the existing house state of 100W has persisted for a very long period (say 20 minutes) this is much longer than any device is expected to be in a rest state for (excluding fridges, which may be dealt with by a separate algorithm), thus any new house states featuring active devices in a rest state will be assigned zero probability and excluded in S903.

In S904, these house state survival probability values are normalised, and any existing house states, i.e. house states at t-1, whose survival probabilities are below a sixth threshold value are excluded. In an embodiment, the sixth threshold value is 2% of the highest survival probability value of the existing house states. Thus any candidate house state(s)'s whose relative probability against the others is below a sixth threshold, meaning that one or more appliance has been in its current state longer than the stored model suggests is likely, are excluded.

Thus a set of existing house state models is produced. Although in this method, various tests have been performed to remove unlikely device state changes and existing house state models, alternatively all device state changes and existing house state models may be automatically included.

The following steps S905 to S908 are performed for each existing house state $hs_{t-1,i}$.

For each existing house state, the following steps S905 to S908 are performed for each possible device state change or combination of device state changes. Thus for the example in Figure 8, the following steps may be performed for each combination of sub-transients:

(i) {1}, {2}, {3}
(ii) {1,2}, {3}
(iii) {1,3}, {2}
(iv) {1}, {2,3}
(v) {1,2,3}

and for each device state change(s) corresponding to each event. As described above, some of the device state change(s) may have been excluded in S902 for example. In an embodiment, the heating device superclass is also replaced by the individual devices at this stage.

In these steps, new house states are generated by updating the existing house state models to reflect each allowed change in state of one or more of the devices. In step S905 the allowed changes in state and thus the allowed new house states are determined according to a stored set of rules and a stored model.

Thus rather than using a transition matrix that holds the probabilities of each house state transitioning to any other house state, only transitions that match certain criteria in combination with the stored model are considered and generated in S905. The criteria or rules may comprise one or more of the following:

- Only a single device may change state at any one time step. However, where the input to the method comprises information output from the method described in Figure 2(b) for example, where sub-events may be separated, this criteria is not included and consideration of more than one device switching for a single time step is allowed where certain further criteria are met. The criteria may be for example, that one or more of the devices is known to be in the house with a high probability.
- Only house state models having a total signal magnitude less than the current total signal value of the utility signal may be generated.
- Devices can only change state at the time that an event was detected in the power stream, i.e. at time step t.
- The only state changes allowed are those expected to create power observations of the same sign as that observed;
- The only state changes allowed are those expected to create power observations of the same approximate magnitude as that observed. The expected observations can be determined from a learned signal difference probability distribution generated during training, as described in relation to Figure 10 below.
- The only state changes allowed are those into a different state to the existing state (i.e. if a device is already on in the existing house state, it cannot then turn on) according to the stored model of the device state changes and allowed transitions.

Thus criteria are used in combination with the stored model of the available devices and the type of transitions allowed for each type of device. In the stored model, most devices are limited to one instance, however some, such as electric hobs and halogen lighting may be allowed multiple instances. The model may be based on user data for example. The criteria specify that only new house states with permitted device transitions and states according to the stored model are generated. Further criteria, such as those based on the magnitude of the signal may also be included.

In the stored model, some devices may have multiple state changes. For example, a washing machine can be modelled as having two dominant components, its heating element ('HE') and its motor ('M') which can be modelled as functioning independently and as having their own binary work/rest states. The heating element and motor both vary somewhat predictably throughout a wash cycle, with the former being more active at the beginning and the latter being active at the end, thus there is some dependency, however, once information regarding duration is included (using the method described in relation to Figure 9 for example) they can be treated as functioning independently. This results in four possible states for the washing machine: {off, rest, HE, M} where 'rest' implies that both HE and M are resting, 'HE' implies HE is working and M is resting, and so on.

All other transitions are considered to have zero probability and house states which do not meet the criteria are not generated. This equates to having a large and very sparse transition matrix.

Thus in an embodiment, the possible house states are determined based on the magnitude and sign of the power change. Transitions are sought which would be an 'emission' or power step similar to the one observed in the event which was received as input. Transitions that would have an emission with a power step of the opposite sign to the observation are automatically excluded, and a new house state corresponding to this combination of the existing house state and device state transition is not created. To examine the suitability of the transmission to the observed power step, a probability is obtained by querying a fitted parametric signal difference probability distribution, generated during training.

For example, if the power consumption in the house at a given time is 1300W and this power level has been reached by a 1200W step-up from a consumption level of 100W (which may be treated as a background level, i.e. no devices are in an active state), then based on the assumptions above, the only house states that we treat as having non-zero probability and thus generate are:

i) those featuring a device capable of 'emitting' a 1200W stepup;
and
ii) those transitioning into an active state, i.e. a state in which the device is both actually in use and also appears on because it is consuming power, for example the "work" state of work/rest devices but not the "rest" state.

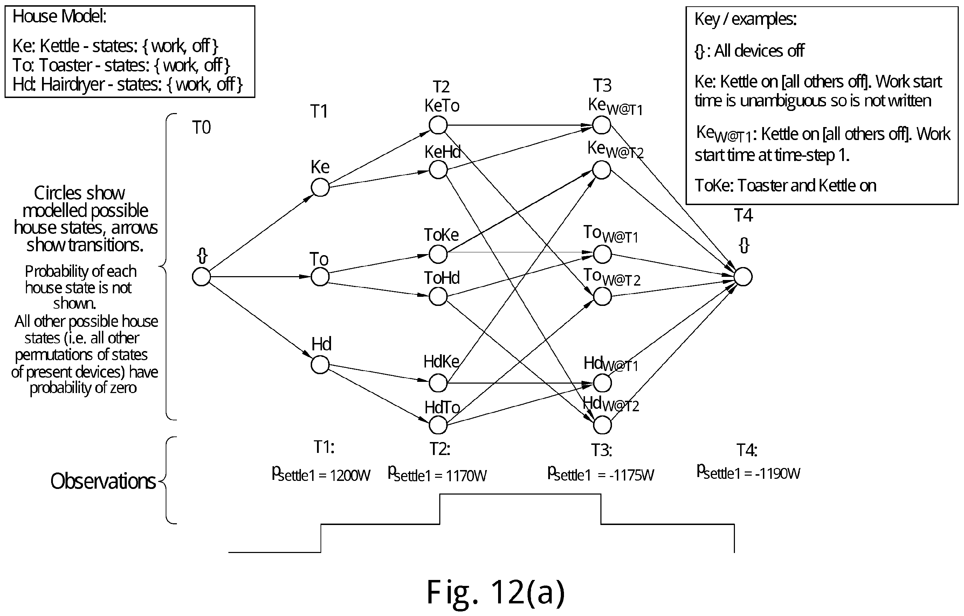

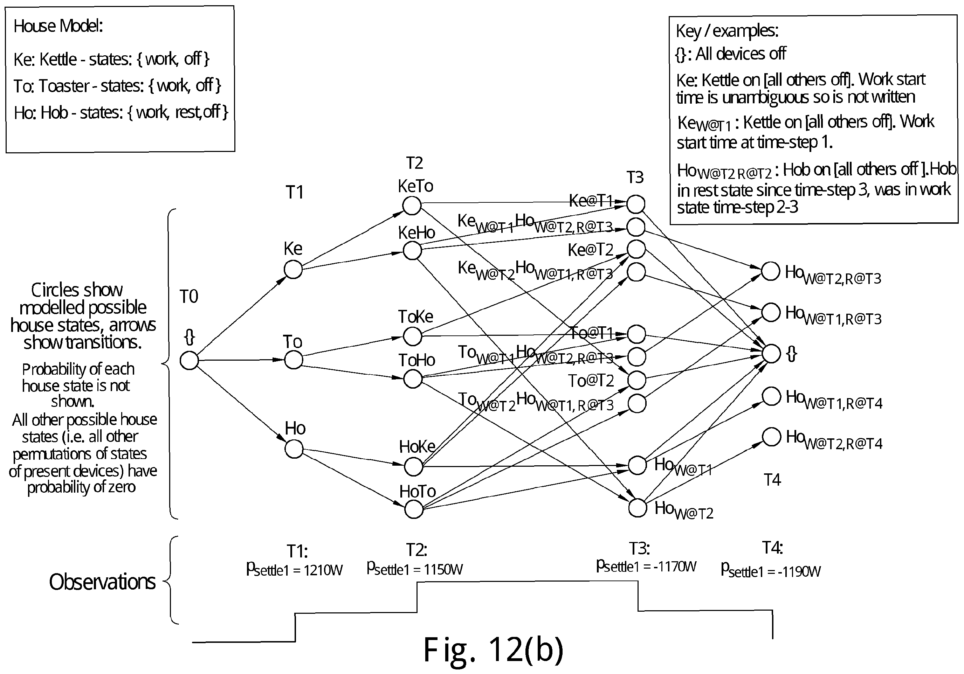

In this case, the only possible new house states as determined in S905 are those in which all devices are off except for one, and that one must be a device that we believe could operate around 1200W. This corresponds to the situation depicted at time T1 in the examples shown in Figures 12(a) and (b) shown below.

In an embodiment, in S905, only new house states for which the device state change (e.g. on to off) is allowed, given the devices' state in the existing house state and one more rules are generated.

Whilst the total number of possible house states is equal to $\Pi_{d \subset devices} m_d$, the overwhelming majority of these states and the transitions into them can be modelled as having zero probability at time T in this step, i.e. are not allowed according to the stored criteria and model as the observations do not fit with them, and thus are not generated.

The method then proceeds to S906, in which house states corresponding to the allowed houses states determined in S905 are generated or updated for each combination of existing house state and device state change(s) remaining after S902 and S904.

For a particular existing house state combined with a device state change from S →S', in S906, it is checked whether a house state $hs_{t,j}$ with appliance d in state S' and with the same state duration, and with the other appliances in the states in which they were in the existing house state with the same duration, already exists. Such a house state may have been created when steps S905 to S908 were performed for another existing house state and device state change combination, i.e. arriving at the same house state via a different path(s). Such a house state will have an associated total house state probability value $P(hs_{t,j})$, generated from the information relating to the different path(s) and an associated most likely path $argmax(p(hs_{1:t,j}))$ or state history, and the house state probability value of that path $max(p(hs_{1:t,j}))$.

If not then a new house state is generated, by updating the existing house state model to reflect the change in state of the or each device. Thus the stored information for the new house state model comprises the stored information for the existing house state model, with the state and state duration for the or each device updated. The state duration is updated to 0, and the state durations of any other active devices in the house state model are updated to take into account the time step. The house state probability value is initially set to zero.

Figure 12(a) shows an example of all the possible house state models at time steps T0 to T4, for the case of three devices, each having two states, on and off, for the example power signal shown. The three devices are kettle, toaster and hairdryer. Time T0 corresponds to the background house state. At time T1, there is a single increase in power, meaning that the only house states allowed in S905 according to the stored criteria are {kettle on, toaster and hairdryer off}, {toaster on, kettle and hairdryer off}, {hairdryer on, toaster and kettle off}, since for this example the rule that only one device may change state at each time step is applied in S905.

At time T2, each of these house states are the existing house states. New house states are generated (or updated if they are found already to exist in S906) by updating each existing house state, again based on the above stored rules in S905, including that only one device may change state at each time step in this case. As the next time step corresponds to another increase, again the only house states allowed according to the stored rules in S905 are those in which another device turns on (i.e. where the sign matches that of the observed signal). Furthermore, only devices which are off in the existing house state can be updated to on in the new house state.

At time T3, there is a step down in power, thus the only allowed new house states according to the stored criteria in S905 are those in which one of the active devices in the existing house states at T2 switches off, leaving the other on. Here, there are six new house states generated, e.g. for the house state in which the kettle is left on, there is a first new house state in which the kettle was turned on at T1 and a second new house state in which the kettle was turned on at T2, i.e. the two house states have different state durations for the kettle. Thus different house states are generated for the different state durations for each device. Furthermore, for each new house state, there are two different "paths", each of which will have a different associated probability. These are summed to give a total house state probability value which is stored. T4 corresponds to another switching off event, thus the only allowed new house state according to the stored criteria is the background house state.

Figure 12(b) shows a second example, in which the third device is a hob, having states {work, rest, off} instead of a hairdryer. The increase in possible states means that there are now 10 possible new house states at time T3. This is because for the house states at T3 in which the kettle or the toaster is the only device left on, the hob may either be off or in the rest state.

In S907, a new house state probability value for the house state model is calculated from the house state probability value of the existing house state and the event probability value or values corresponding to the change in state of the device or devices. The total house state probability value $P(hs_{t,j})$ is then updated by adding the new house state probability value to the current total house state probability value, resulting in a new total house state probability value.

The new house state probability value may also be calculated from one or more of a signal difference probability value, which is the probability that the difference in magnitude of the utility consumption signal was caused by the device; a transition probability value, which is the probability that the change in state of the device occurs at the time location of the first portion given the state duration; a prior probability value, which is the probability of device state change relative to the other devices; and a survival probability value and/or hazard rate corresponding to each device which is in an active state in the existing house state, wherein the survival probability value is the probability that the device remains in the state given the state duration. All of these probabilities may be stored values or values generated from stored distributions. These stored values and distributions are generated prior to implementation, from training data.

In an embodiment, the new house state probability $P(hs_{t,j})$ is the product of one or more of:

- the total probability of the existing house state $hs_{t-1,i}$, $P(hs_{t-1,i})$
- the event probability value(s) of the device(s) $P_{classifier}$;
- the appropriate prior (either switch-on prior or active state change prior) $P_{prior}$;
- the survival probability and/or hazard rate of all active devices from the existing house state $hs_{t-1,i}$ other than the device or devices which changed state $\Pi P_{survival}$ (other devices);
- the transition probability of the device(s) which changed state at this instance in time given the state duration $P_{transition}$;
- the signal difference probability, i.e. the probability that the difference in magnitude of the utility consumption signal was caused by the device, based on the range of possible power steps for this appliance $P_{signal}$ difference.

The transition probability is only included where the device is transitioning from an active state.

Thus for example:

$$P(\text{Microwave\_on}) = P_{classifier}(\text{Microwave}) * P_{prior\_switchon}(\text{Microwave}) * P_{signal}$$
$$_{difference}(\text{Microwave\_on}) * P_{transition\_offon}(\text{Microwave\_on})$$

and

$$P(hs_{t,j}) = P(\text{Microwave\_on}) * P(hs_{t-1,i}) * \prod P_{survival}(\text{other devices})$$

Where two or more devices change state at the time step, the probability values for each device are included in the product.

In an embodiment, the logarithm of the probability values are used in this step to combine the probabilities, to avoid numerical underflow.

For each house state model, the above probabilities for each path are summed to give the total house state probability. The total house state probability value is thus updated by adding the new house state probability value to the current total house state probability value, resulting in a new total house state probability value.. The house state $hs_{t,j}$ will already have a stored total house state probability value, for example 0 if the house state was generated in S906, and a previously generated value if the house state was already created in S906 (i.e. it was created when steps S905 to S908 were performed for another existing house state and device state change combination). The new house state probability value generated in S907 is summed with this stored total house state probability value to give an updated total house state probability value, which is stored.

In an embodiment, the new house state probability value generated in S907 is also compared to the stored most likely path house state probability value in S908. The new house state probability value can be considered as the probability that the house state $hs_{t,j}$ was reached via the house state $hs_{t-1,i}$ and the device state change. If this path to $hs_{t,j}$ has a higher probability than the previous most likely path to $hs_{t,j}$, which is stored, then information identifying this path as the most likely path to $hs_{t,j}$ is stored instead. Thus in this step, the most likely path to $hs_{t,j}$ is updated to $hs_{t-1,i}$ plus the step from $hs_{t-1, i}$ to $hs_{t, j}$ (i.e. the device state change(s)) and its probability stored. If it does not have a higher probability, then the most likely path is not updated.

Once these steps have been performed for all of the existing house states and all of the device state changes or combinations of device state changes, there results a set of house state models, with corresponding house state model probability values and most likely path information and probability values.

In an embodiment, these values are then normalised, so that the sum over all the house state probability values is 1. These normalised probability values may be referred to as marginal probability values.

In S910, for each device d, the total probability of it being in each of its allowed states (e.g. {on, off} or {on, rest, off}) at t is obtained. In an embodiment, this is done by, for each state S of the device, taking a sum of the marginal probability of each new house state containing the device d in the state S (e.g. 'on') at t, and normalising the total probabilities of each state of d so that they sum to one. This gives the probabilities of each state of d at t. This may be the final output from the system to the front end app for example.

The below provides a description of an example sequence of events.

(i) 20 mins since the previously observed event, a new event is detected, e.g. by the method described in relation to S102, and the corresponding information, e.g. found in the method described in relation to Figure 2(b), inputted into the probabilistic model described in relation to Figure 9. The event is a plateau event with a negative magnitude step of 2200W. The classifier output for this event is {'Heating Device': 0.90, 'Vacuum': 0.01, 'Washing Machine Motor': 0.03, 'Microwave': 0.06}.The classifier output may be generated by the method described in relation to Figure 2(b) above, or by another classifier.

(ii) The Vacuum Cleaner and Washing Machine motor are below the fifth threshold value, which in this case is 0.05, and are excluded in S902.

(iii) The survival probabilities of each house state model from the previous observation time step are updated in S903. These probabilities are the combined survival probabilities of each device that was in an active state in that house state model.

(iv) The house state survival probabilities from the previous step are normalised and any below a threshold are excluded in S904. States likely to be excluded, for example, would be any that modelled a kettle being on since the previous observed event 20 minutes ago (highly unlikely).

(v) For each surviving house state $hs_{t-1, i}$ from the previous time step:
For each device state change d of {'Heating Device', 'Microwave'}, where the "Heating Device" superclass is replaced with the list of individual devices:

　　a) if the change in the device's state is allowed from $hs_{t-1, i}$, according to the stored rules in S905, then a new house state $hs_{t, j}$ is created in S906 (if it doesn't already exist), in which d has made said state change. In this case since a decrease in energy has been observed, the device must have been in an active state in the surviving house state and the transition will be to a lower energy state.
　　b) calculate the new house state probability of $hs_{t, j}$ by multiplying forward the probability of $hs_{t-1, i}$ by the combined survival probability of its non-transitioning active devices, the appropriate prior for this transition, the classifier output probability, the signal difference probability and by the transition probability according to the transition function, in S907.
　　c) update the total house state probability with this value, and, if this path from $hs_{t-1, i} \rightarrow hs_{t, j}$ is more likely than any other path, then save $hs_{t, j}$'s state history as the state history, i.e. the most likely path, of $hs_{t-1, i}$ plus the transition $hs_{t-1, i} \rightarrow hs_{t, j}$.

While there are a large number of device state changes, only a small subset will have house states that end up having sufficient probability in (v)(b), since most will not have a large emission probability around the observed step magnitude (2200W).

The above described method tracks the most probable combination of active appliance states.

The method may store and update information relating to each event or sub-event, for example in a table containing one or more of the following columns:

　　i) 'Power Before' The active power before the event occurred e.g. 132.54 (Watts)
　　ii) 'Power After' The active power after the event occurred e.g. 2232.54 (Watts)
　　iii) 'Power Step' The change in active power over the period of the event or subevent e.g. 2100.0 (Watts)

iv) 'Device Name' The most probable classification name of this step event, according to the current most likely path e.g. Microwave

v) 'Mains ID' A unique identifier for the live wire carrying the event or subevent, so that the tracking system can quickly filter for events happening on a particular mains wire e.g. either {0, 1}

vi) 'Library ID' A unique identifier for this 'device name' to link to a static library e.g. 21

vii) 'Device List' An array containing the list of other active appliances before the event occurred e.g. 'Background, Kettle'

viii) 'Step Event' A pointer to the class object containing the event information

Where output data from the method described in relation to Figure 2(b) is the input information to the method described in relation to Figure 9, many of these fields are populated directly from the detected event or sub-event in Figure 2(b), and are included for fast filtering and analytics on the method described in relation to Figure 9. In an embodiment, each House State (each containing a possible combination of active appliances) stores the necessary information to populate this table. The tracking table outputted to the user may be finally populated from the House State with the highest probability at the given instance in time that a request is made (e.g. this may be on-demand based, or every second for live appliance tracking and display).

Figure 10 is a method of training the probabilistic model, which is performed on the system before implementation. This method generates the stored data, which is used by the model to process the utility consumption data. Figure 10 shows a flow chart of a method of adapting a system configured for processing utility consumption data, for example as described in relation to Figure 9.

The training stage may comprise learning (i) the transition probabilities and (ii) the emission probabilities, which correspond to the signal difference probability. The emission probabilities are the probabilities that a hidden state causes certain observations. In this case, this means the probability that the device being in a certain state causes observations in the utility consumption signal. For example, that the microwave being in the 'on' state causes a signal change of 1050W to be observed on the power line.

For each device class, i.e. type of device, and optionally each sub-class the following steps are performed:
A training data set is loaded, comprising labelled appliance power consumption data. The data may be low frequency data for example 1Hz or lower. The power consumption data comprises annotations of which discrete states the appliance was in at each time step. The data may be hand-labelled for example or labelled in a semiautomatic manner.

For each active state transition for the device, the following steps S1002 to S1004 are performed in order to generate the transition probability model. An active state transition is a transition from a non-off state, i.e. an active state, into any other state.

In S1002, for the transition S → S', for all state pairs S , S' subject to S ≠ S' and S ≠ 'off ', the training data set is searched for all of the instances of the device being in state S then changing to state S'. The duration of state S prior to the transition to S' is extracted from each instance found, and these duration values form an empirical distribution. Thus S1002 comprises extracting an empirical distribution of the device state duration prior to an active state transition.

In S1003 a suitable parametric distribution is fitted to the empirical distribution of the state duration. For example, a gamma distribution may be fitted to the empirical distributions of state durations.

In S1004, this parametric distribution and its cumulative distribution function are stored. These distributions are then used to calculate the state transition and survival probability values during implementation. The distribution is the distribution of the probability of the transition occurring with state duration.

Thus prior knowledge of the duration characteristics of types of devices is incorporated into the method through the transition probability. These duration based switching probabilities are learned from a training data set, which may comprise public and/or private household power consumption data. Corresponding state durations are found for each device type (e.g. on-state durations for kettles, 'work' and 'rest' state durations for Hobs etc.) and a suitable parametric distribution, such as a student-t or gamma distribution, is fit to this data. This parametric distribution is then used to generate the survival function and/or hazard rate for the given device type and transition probability.

An example of where this is an important factor is in the classification of a Kettle vs. a Dishwasher. Both of these devices feature heating elements which frequently can be rated 3000W. At the point of detection (switch on), there may be no way to distinguish these heating elements from each other. However, Kettles rarely boil for more than 5 minutes, whereas Dishwasher heating elements remain on for much longer. While the kettle may be the most likely explanation for the observed event at the at the point of detection, at some point after 5 minutes having elapsed, the method will begin to favour the dishwasher as being the explanation for the long duration 3000W power consumption (thus the house states with the dishwasher on will have higher probabilities).

Furthermore, if after 15 minutes of the 3000W heating element being observed on, another 3000W resistive switch-on is seen in the power signal, then the method will determine that a kettle was responsible for this observation with high probability. This is because at the point of this second 3000W event being observed, there is already a high probability that the dishwasher is on, i.e. where the house state or states in which the dishwasher is on have high probability, and the house model assumes there is only one dishwasher in the house (meaning that house state models in which multiple dishwashers are on are not permitted according to the criteria in S905, and therefore another device must be responsible. This corresponds to the branching seen in Figures 12(a) and (b), where, for example, after the Toaster is already on in a given house state, the only transitions that are allowed in response to a second 'on' observation are those where a non-Toaster device turns on.

The available devices and the types of transitions allowed for each type of device is modelled and the model is stored and used to implement the criteria in S905. This may be done in the training stage, from the training data for example, or may be input by the user. For an on/off device, the only transition that needs to be modelled is the 'on' → 'off' transition. However in a work/rest device, three transitions are modelled: 'work' → 'rest', 'rest' → 'work' and 'work' → 'off'.

S1005 is then performed in order to generate the active state prior probability values. This step comprises recording the total number of active state transitions per unit time for the particular device. In other words, the total number of transitions from a non-off state to any other state for the device observed during a particular time period from each data set in the training set is recorded. Thus the active state change priors can be considered as the relative frequencies of a device changing from an active state. For example, for washing machines in the heating state, the probability of transitioning to the motor state is 52%. This value is determined from extracting the number of washing machine transitions from the heating state to the motor state compared to transitions to other subsequent states in training data. The probability of transitioning from the heating state to the rest state may be 41% and to the off state 7%. These values are stored as the active state prior probabilities.

S1006 is performed in order to generate the switch-on prior probability values. This step comprises recording the total number of switch on transitions per unit time for the particular device. In other words, the total number of transitions from an off state to any other state for the device observed during a particular time period from each data set in the training set is recorded. Thus the switch on priors can be considered to be the relative frequencies of the devices switching on, as observed across a range of houses. For example, where the average number of switch on events for a kettle is 5 switch ons per day; for hairdryers is 4 switch ons per day and for toasters is 1 switch on per day, the prior switch on probabilities will be: (Kettle: 0.5, Toaster: 0.1, Hairdryer: 0.4).

S1007 and S1008 are performed in order to generate the emission probabilities, i.e. the signal difference probabilities.

All of the power step values are extracted from the training data set for each state transition for the device. Thus an empirical distribution of the probability against size of power step, or signal difference is generated for each transition type. A suitable parametric distribution is then fitted to the empirical power step data. A Student-t distribution may be used in this step. During implementation, the signal difference probability is determined from this stored signal difference probability model, i.e. by extracting the probability value corresponding to the signal difference value.

In an embodiment, the stored probabilities and models may be updated based on one or more of self-learning from the data inputted during implementation, user feedback and active learning through a user interface (interactive app or website for example). Thus the system may be a user or site specific system, which learns and adapts by online updating of one or more of the stored probability values or distributions based on user feedback, active learning and probabilistic confidences from the tracking system.

In an embodiment, the method described in relation to Figure 9 and 10 above is based on a Bayesian time series approach such as a Factorial Hidden Markov Model (FHMM). The method is based on determining the latent or "hidden" state of multiple independently functioning devices through time. Each device is modelled as a single latent categorical variable (at a minimum there must be two states: "on" and "off"). In an embodiment, the method is based on a factorial hidden semi-Markov model (FHSMM) with a sparse transition matrix and sparse time points. Within the model, probabilities are passed from the states of one time-step and multiplied by various transition probabilities to determine the state probabilities of the next time-step. This process is named "sum-product-message passing" or "belief propagation", and is the basic mechanism by which inference is performed.

The model explicitly (i) tracks a specified number of devices in the home, and (ii) models each of these tracked devices as having a number of pre-defined discrete states which consume energy at different power levels. That these states are not directly observable but instead are something to be inferred from the powerline observations is the hidden Markov property of the FHSMM. These states are explicitly hardcoded for each device, and transition functions between them learned. This way of modelling multiple independently functioning devices is the factorial property of the FHSMM.

The method generates the probabilities of states surviving or changing by referring to the stored survival curve of a learned parametric distribution which models a device's chance of changing state given the duration that it has been in that active state. This mechanism allows the model, in an embodiment, to only be updated at time points when events are passed into the model. Events are may be sparse and irregular. Only updating the model when events are observed makes a computational cost saving versus updating at a regular time interval, e.g. once a second.

In an embodiment, the model can also be queried when no events have been observed. This is useful for checking whether the most likely house state and explanation for the observed energy patterns has changed, i.e. whether house state models still survive given the duration of continuing steady states. In an embodiment, if the device has a heavy computational load it can refrain from doing this.

The probability of a modelled device transitioning from an active state to any other state is only semi-Markov, as it is governed by a transition function, rather than a constant transition probability. The transition function determines the probability of transition given the length of time the device has been in the active state. These transition functions are pre-trained from a large corpus of data and stored.

Each house state is a combination of each allowed set of states of each device in the house according to the stored model and criteria. As the number of devices modelled rises, the number of possible house states rises exponentially. Furthermore, the semi-Markov property means that each house state records the duration(s) that each device has been in its current state, and this increases the storage space required to store the possible states to be even larger.

The method described in relation to Figure 9 above comprises tracking of appliance activity using a bespoke probabilistic model that (i) makes hard-coded assumptions about the devices present in an as yet unobserved residence and their behaviour, based on a training data set. These strong assumptions achieve tractability on a system with constrained resources, such as an IoT device.

The method allows processing to be performed only when an event is detected, i.e. with sparse time steps and takes into account transition probabilities generated from a reliability/hazard function, thus analysing the state duration as a feature.

The methods described in relation to Figures 2(b) and 9 above can be combined, such that information outputted from Figure 2(b) is then inputted into the method of Figure 9, enabling integration of classification based on the high-speed features of the utility consumption signal with those based on duration of the device states for example. The method described in relation to Figure 9 can be integrated with an initial event separation as input.

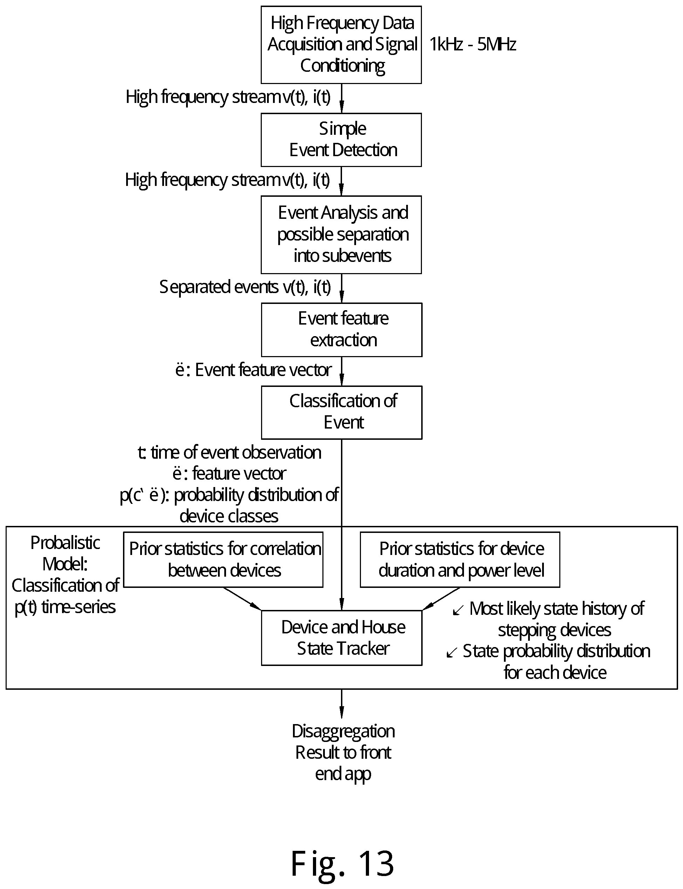

Figure 13 shows a flow chart illustrating a method of processing a utility consumption signal in accordance with an embodiment. The utility consumption signal is acquired and signal conditioning may be performed. Event detection and analysis are performed as described in relation to Figure 2(b)(i) for example, followed by separation of the event into sub-events, feature extraction and classification of the event as described in relation to Figure 2(b)(ii). The classification, comprising the time of the event observation, the feature vector and the probability distribution of device classes is then input into the method described in relation to Figure 9 above, which uses a probabilistic model together with prior statistics for correlation between devices and for device duration and power level to determine the most likely state history of stepping devices and state probability distribution for each device. The disaggregation result from this model is output to the front end app.

The above described methods can be combined in a machine learning based method for monitoring utility consumption data for a unit such as a building, for example a residential home, and separating utility consumption data into data corresponding to individual devices. The most likely series of the set of device state variables through time is the disaggregation result and is the output of the model.

In an embodiment, the method is implemented on an IoT device.

While certain embodiments have been described, these embodiments have been presented by way of example only, and are not intended to limit the scope of the invention as claimed. Indeed the novel methods and apparatus described herein may be embodied in a variety of other forms; furthermore, various omissions, substitutions and changes in the form of methods and apparatus described herein may be made without departing from the scope of the invention as claimed. The accompanying claims and their equivalents are intended to cover such forms of modifications as would fall within the scope of the invention as claimed.

## Claims

1.  A utility consumption data processing system, the system comprising:

    an input for receiving utility consumption data relating to a utility consumption signal;
    an output for outputting information relating to changes in state of a plurality of devices corresponding to changes in the utility consumption signal; and
    a processor configured to:

    obtain a list of possible device state changes and corresponding event probability values for a first portion of the utility consumption signal comprising a change in magnitude of the signal;
    generate one or more house state models, wherein a house state model comprises stored information indicating a state for each device and indicating a state duration for the device if in an active state, wherein generating one or more house state models comprises updating one or more existing house state models to reflect each allowed change in state of one or more of the devices;

calculate a house state probability value for each house state model, wherein the house state probability value is calculated from the house state probability value of the existing house state model which was updated to generate the house state model and an event probability value corresponding to the change in state of the one or more devices, and from one or more of a transition probability value and a survival probability value corresponding to each device which is in an active state, wherein the transition probability value is the probability that the change in state of the device occurs given the state duration and is generated from a stored probability distribution, and the survival probability value is the probability that the device remains in the state given the state duration and is generated from a stored probability distribution.

2. The system according to claim 1, wherein the house state probability value is also calculated from one or more of a signal difference probability value, which is the probability that the size of the change in magnitude of the utility consumption signal was caused by the device and a prior probability value, which is the relative probability of the device transition, wherein the signal difference probability value and prior probability value are stored values or are generated from stored probability distributions.

3. The system according to claim 1 or 2, the processor being further configured to:
exclude from the inputted list any device state changes corresponding to an event probability value below a fifth threshold value.

4. The system according to any of claims 1 to 3, wherein the allowed changes in state are determined according to a stored set of rules.

5. The system according to any of claims 1 to 4, the processor being further configured to:

for each of the one or more existing house state models, determine the survival probability value corresponding to each device which is in an active state; and
determine a house state survival probability value from the survival probability values corresponding to the devices in an active state;
if the house state survival probability value is below a sixth threshold value, exclude the existing house state model.

6. The system according to any of claims 1 to 5, the processor being further configured to:

calculate the total signal magnitude of each house state model;
if the total magnitude is larger than the utility signal, exclude the house state model.

7. The system according to any of claims 1 to 6, the processor being further configured to:
exclude any house state models having a house state model probability value below a seventh threshold value.

8. The system according to any of claims 1 to 7, the processor being further configured to:

calculate the number of house state models;
if the number of house state models is larger than an eighth threshold value, exclude a fixed number of the house state models having the lowest house state model probability values.

9. The system according to any of claims 1 to 8, wherein a house state model further comprises stored information indicating the most likely previous existing house state model and transition from the previous existing house state model to the house state model.

10. A method of processing utility consumption data, comprising:

obtaining a list of possible device state changes and corresponding event probability values for a first portion of a utility consumption signal comprising a change in magnitude of the signal;
generating one or more house state models, wherein a house state model comprises stored information indicating a state for each device and indicating a state duration for the device if in an active state, wherein generating one or more house state models comprises updating one or more existing house state models to reflect each allowed change in state of one or more of the devices;
calculating a house state probability value for each house state model, wherein the house state probability value

EP 3 290 869 B1

is calculated from the house state probability value of the existing house state model which was updated to generate the house state model and an event probability value corresponding to the change in state of the one or more devices, and from one or more of a transition probability value and a survival probability value corresponding to each device which is in an active state, wherein the transition probability value is the probability that the change in state of the device occurs given the state duration and is generated from a stored probability distribution and the survival probability value is the probability that the device remains in the state given the state duration and is generated from a stored probability distribution.

11. A carrier medium comprising computer readable code configured to cause a computer, which is adapted to obtain a list of possible device state changes and corresponding event probability values, to perform the method of claim 10.


**Patentansprüche**

1. Versorgungsverbrauchsdaten-Verarbeitungssystem, wobei das System Folgendes umfasst:

    einen Eingang zum Empfangen von Versorgungsverbrauchsdaten, die mit einem Versorgungsverbrauchssignal in Beziehung stehen;
    einen Ausgang zum Ausgeben von Informationen, die auf Zustandsänderungen mehrerer Vorrichtungen bezogen sind, die Änderungen des Versorgungsverbrauchssignals entsprechen; und
    einen Prozessor, der konfiguriert ist zum:

       Erhalten einer Liste möglicher Vorrichtungszustandsänderungen und entsprechender Ereigniswahrscheinlichkeitswerte für einen ersten Abschnitt des Versorgungsverbrauchssignals, der eine Änderung der Größe des Signals enthält;
       Erzeugen eines oder mehrerer Hauszustandsmodelle, wobei ein Hauszustandsmodell gespeicherte Informationen enthält, die einen Zustand jeder Vorrichtung angeben und eine Zustandsdauer für die Vorrichtung, falls sie in einem aktiven Zustand ist, angeben, wobei das Erzeugen eines oder mehrerer Hauszustandsmodelle ein Aktualisieren eines oder mehrerer vorhandener Hauszustandsmodelle umfasst, um jede erlaubte Zustandsänderung einer oder mehrerer Vorrichtungen zu reflektieren;
       Berechnen eines Hauszustand-Wahrscheinlichkeitswertes für jedes Hauszustandsmodell, wobei der Hauszustand-Wahrscheinlichkeitswert aus dem Hauszustand-Wahrscheinlichkeitswert des vorhandenen Hauszustandsmodells, das aktualisiert wurde, um das Hauszustandsmodell zu erzeugen, aus einem Ereigniswahrscheinlichkeitswert, der der Zustandsänderung der einen oder der mehreren Vorrichtungen entspricht, aus einem oder mehreren Übergangswahrscheinlichkeitswerten und aus einem Überlebenswahrscheinlichkeitswert, der jeder Vorrichtung, die in einem aktiven Zustand ist, entspricht, berechnet wird, wobei der Übergangswahrscheinlichkeitswert die Wahrscheinlichkeit dafür ist, dass die Zustandsänderung der Vorrichtung bei gegebener Zustandsdauer auftritt, und aus einer gespeicherten Wahrscheinlichkeitsverteilung erzeugt wird, und der Überlebenswahrscheinlichkeitswert die Wahrscheinlichkeit dafür ist, dass die Vorrichtung in dem Zustand bei gegebener Zustandsdauer verbleibt, und aus einer gespeicherten Wahrscheinlichkeitsverteilung erzeugt wird.

2. System nach Anspruch 1, wobei der Hauszustand-Wahrscheinlichkeitswert außerdem aus einem Signaldifferenz-Wahrscheinlichkeitswert, der die Wahrscheinlichkeit dafür ist, dass das Ausmaß der Größenänderung des Versorgungsverbrauchssignals durch die Vorrichtung verursacht wurde, und/oder aus einem früheren Wahrscheinlichkeitswert, der die relative Wahrscheinlichkeit des Vorrichtungsübergangs ist, berechnet wird, wobei der Signaldifferenz-Wahrscheinlichkeitswert und der frühere Wahrscheinlichkeitswert gespeicherte Werte sind oder aus gespeicherten Wahrscheinlichkeitsverteilungen erzeugt werden.

3. System nach Anspruch 1 oder 2, wobei der Prozessor ferner konfiguriert ist zum:
Ausschließen aus der eingegebenen Liste irgendwelcher Vorrichtungszustandsänderungen, die einem Ereigniswahrscheinlichkeitswert unterhalb eines fünften Schwellenwertes entsprechen.

4. System nach einem der Ansprüche 1 bis 3, wobei die erlaubten Zustandsänderungen in Übereinstimmung mit einer gespeicherten Menge von Regeln bestimmt werden.

5. System nach einem der Ansprüche 1 bis 4, wobei der Prozessor ferner konfiguriert ist zum:

# EP 3 290 869 B1

Bestimmen des Überlebenswahrscheinlichkeitswertes, der jeder Vorrichtung entspricht, die in einem aktiven Zustand ist, für jedes des einen oder der mehreren vorhandenen Hauszustandsmodelle; und

Bestimmen eines Hauszustand-Überlebenswahrscheinlichkeitswertes aus den Überlebenswahrscheinlichkeitswerten, die den Vorrichtungen in einem aktiven Zustand entsprechen;

Ausschließen des vorhandenen Hauszustandsmodells, falls der Hauszustand-Überlebenswahrscheinlichkeitswert niedriger als ein sechster Schwellenwert ist.

6. System nach einem der Ansprüche 1 bis 5, wobei der Prozessor ferner konfiguriert ist zum:

Berechnen der Gesamtsignalgröße jedes Hauszustandsmodells;
Ausschließen des Hauszustandsmodells, falls die Gesamtgröße größer als das Versorgungssignal ist.

7. System nach einem der Ansprüche 1 bis 6, wobei der Prozessor ferner konfiguriert ist zum:
Ausschließen irgendwelcher Hauszustandsmodelle, die einen Hauszustandsmodell-Wahrscheinlichkeitswert unter einem siebten Schwellenwert besitzen.

8. System nach einem der Ansprüche 1 bis 7, wobei der Prozessor ferner konfiguriert ist zum:

Berechnen der Anzahl von Hauszustandsmodellen;
Ausschließen einer festen Anzahl der Hauszustandsmodelle, die die niedrigsten Hauszustandsmodell-Wahrscheinlichkeitswerte besitzen, falls die Anzahl von Hauszustandsmodellen größer als ein achter Schwellenwert ist.

9. System nach einem der Ansprüche 1 bis 8, wobei ein Hauszustandsmodell ferner gespeicherte Informationen enthält, die das wahrscheinlichste frühere vorhandene Hauszustandsmodell und den Übergang von dem früheren vorhandenen Hauszustandsmodell zu dem Hauszustandsmodell angeben.

10. Verfahren zum Verarbeiten von Versagungsverbrauchsdaten, das Folgendes umfasst:

Erhalten eine Liste möglicher Vorrichtungszustandsänderungen und entsprechender Ereigniswahrscheinlichkeitswerte für einen ersten Abschnitt eines Versorgungsverbrauchssignals, der eine Größenänderung des Signals enthält;

Erzeugen eines oder mehrerer Hauszustandsmodelle, wobei ein Hauszustandsmodell gespeicherte Informationen enthält, die einen Zustand für jede Vorrichtung angeben, und eine Zustandsdauer der Vorrichtung, falls sie in einem aktiven Zustand ist, angeben, wobei das Erzeugen eines oder mehrerer Hauszustandsmodelle ein Aktualisieren eines oder mehrerer vorhandener Hauszustandsmodelle umfasst, um jede erlaubte Zustandsänderung einer oder mehrerer Vorrichtungen zu reflektieren;

Berechnen eines Hauszustand-Wahrscheinlichkeitswertes für jedes Hauszustandsmodell, wobei der Hauszustand-Wahrscheinlichkeitswert aus dem Hauszustand-Wahrscheinlichkeitswert des vorhandenen Hauszustandsmodells, das aktualisiert wurde, um das Hauszustandsmodell zu erzeugen, aus einem Ereigniswahrscheinlichkeitswert, der der Zustandsänderung der einen oder der mehreren Vorrichtungen entspricht, aus einem oder mehreren Übergangswahrscheinlichkeitswerten und aus einem Überlebenswahrscheinlichkeitswert, der jeder Vorrichtung, die in einem aktiven Zustand ist, entspricht, berechnet wird, wobei der Übergangswahrscheinlichkeitswert die Wahrscheinlichkeit dafür ist, dass die Zustandsänderung der Vorrichtung bei gegebener Zustandsdauer auftritt, und aus einer gespeicherten Wahrscheinlichkeitsverteilung erzeugt wird, und der Überlebenswahrscheinlichkeitswert die Wahrscheinlichkeit dafür ist, dass die Vorrichtung in dem Zustand bei gegebener Zustandsdauer verbleibt, und aus einer gespeicherten Wahrscheinlichkeitsverteilung erzeugt wird.

11. Trägermedium, das computerlesbaren Code enthält, der konfiguriert ist, einen Computer, der dafür ausgelegt ist, eine Liste möglicher Vorrichtungszustandsänderungen und entsprechende Ereigniswahrscheinlichkeitswerte zu erhalten, zu veranlassen, das Verfahren nach Anspruch 10 auszuführen.

## Revendications

1. Système de traitement de données de consommation de service public, le système comprenant :

une entrée pour recevoir des données de consommation de service public relatives à un signal de consommation de service public ;

une sortie pour délivrer en sortie des informations relatives aux changements d'état d'une pluralité de dispositifs correspondant à des changements du signal de consommation de service public ; et

un processeur configuré pour :

obtenir une liste de changements d'état de dispositif possibles et de valeurs de probabilité d'événement correspondantes pour une première partie du signal de consommation de service public comprenant un changement d'amplitude du signal ;

générer un ou plusieurs modèle(s) d'état de maison, où un modèle d'état de maison comprend des informations stockées indiquant un état pour chaque dispositif et indiquant une durée d'état pour le dispositif s'il est dans un état actif, où la génération d'un ou de plusieurs modèle(s) d'état de maison comprend la mise à jour d'un ou de plusieurs modèle(s) existant(s) d'état de maison pour refléter chaque changement d'état autorisé d'un ou de plusieurs des dispositifs ;

calculer une valeur de probabilité d'état de maison pour chaque modèle d'état de maison, où la valeur de probabilité d'état de maison est calculée à partir de la valeur de probabilité d'état de maison du modèle existant d'état de maison qui a été mis à jour pour générer le modèle d'état de maison et d'une valeur de probabilité d'événement correspondant au changement d'état du ou des plusieurs dispositif(s), et à partir d'une ou de plusieurs d'une valeur de probabilité de transition et d'une valeur de probabilité de survie correspondant à chaque dispositif qui est dans un état actif, où la valeur de probabilité de transition est la probabilité que le changement d'état du dispositif se produise compte tenu de la durée d'état et est générée à partir d'une distribution de probabilité stockée, et la valeur de probabilité de survie est la probabilité que le dispositif reste dans l'état compte tenu de la durée d'état et est générée à partir d'une distribution de probabilité stockée.

2. Système selon la revendication 1, dans lequel la valeur de probabilité d'état de maison est également calculée à partir d'une ou de plusieurs d'une valeur de probabilité de différence de signal, qui est la probabilité que la taille du changement d'amplitude du signal de consommation de service public ait été provoquée par le dispositif et d'une valeur de probabilité a priori, qui est la probabilité relative de la transition de dispositif, où la valeur de probabilité de différence de signal et la valeur de probabilité a priori sont des valeurs stockées ou sont générées à partir de distributions de probabilité stockées.

3. Système selon la revendication 1 ou 2, le processeur étant en outre configuré pour :
exclure de la liste entrée tout changement d'état de dispositif correspondant à une valeur de probabilité d'événement inférieure à une cinquième valeur seuil.

4. Système selon l'une des revendications 1 à 3, dans lequel les changements d'état autorisés sont déterminés selon un ensemble de règles stocké.

5. Système selon l'une des revendications 1 à 4, le processeur étant en outre configuré pour :

pour chacun du ou des plusieurs modèle(s) existant(s) d'état de maison, déterminer la valeur de probabilité de survie correspondant à chaque dispositif qui est dans un état actif ; et

déterminer une valeur de probabilité de survie d'état de maison à partir des valeurs de probabilité de survie correspondant aux dispositifs dans un état actif ;

si la valeur de probabilité de survie d'état de maison est inférieure à une sixième valeur seuil, exclure le modèle existant d'état de maison.

6. Système selon l'une des revendications 1 à 5, le processeur étant en outre configuré pour :

calculer l'amplitude totale de signal de chaque modèle d'état de maison ;

si l'amplitude totale est supérieure au signal de service public, exclure le modèle d'état de maison.

7. Système selon l'une des revendications 1 à 6, le processeur étant en outre configuré pour :
exclure tout modèle d'état la maison ayant une valeur de probabilité de modèle d'état de maison inférieure à une septième valeur seuil.

8. Système selon l'une des revendications 1 à 7, le processeur étant en outre configuré pour :

calculer le nombre de modèles d'état de maison ;

si le nombre de modèles d'état de maison est supérieur à une huitième valeur seuil, exclure un nombre fixe des modèles d'état de maison ayant les plus faibles valeurs de probabilité de modèle d'état de maison.

9. Système selon l'une des revendications 1 à 8, dans lequel un modèle d'état de maison comprend en outre des informations stockées indiquant le modèle existant d'état de maison précédent le plus probable et une transition du modèle existant d'état de maison précédent au modèle d'état de maison.

10. Procédé de traitement de données de consommation de service public, comprenant le fait :

d'obtenir une liste de changements d'état de dispositif possibles et de valeurs de probabilité d'événement correspondantes pour une première partie d'un signal de consommation de service public comprenant un changement d'amplitude du signal ;

de générer un ou plusieurs modèle(s) d'état de maison, où un modèle d'état de maison comprend des informations stockées indiquant un état pour chaque dispositif et indiquant une durée d'état pour le dispositif s'il est dans un état actif, où la génération d'un ou de plusieurs modèle(s) d'état de maison comprend la mise à jour d'un ou de plusieurs modèle(s) existant(s) d'état de maison pour refléter chaque changement d'état autorisé d'un ou de plusieurs des dispositifs ;

de calculer une valeur de probabilité d'état de maison pour chaque modèle d'état de maison, où la valeur de probabilité d'état de maison est calculée à partir de la valeur de probabilité d'état de maison du modèle existant d'état de maison qui a été mis à jour pour générer le modèle d'état de maison et d'une valeur de probabilité d'événement correspondant au changement d'état du ou des plusieurs dispositif(s), et à partir d'une ou de plusieurs d'une valeur de probabilité de transition et d'une valeur de probabilité de survie correspondant à chaque dispositif qui est dans un état actif, où la valeur de probabilité de transition est la probabilité que le changement d'état du dispositif se produise compte tenu de la durée d'état et est générée à partir d'une distribution de probabilité stockée et la valeur de probabilité de survie est la probabilité que le dispositif reste dans l'état compte tenu de la durée d'état et est générée à partir d'une distribution de probabilité stockée.

11. Support comprenant un code lisible par ordinateur configuré pour amener un ordinateur, qui est adapté pour obtenir une liste de changements d'état de dispositif possibles et de valeurs de probabilité d'événement correspondantes, à effectuer le procédé de la revendication 10.

Fig. 1(a)

House 3: Apr_26
good section #26
slice 46 of 64

Fig. 1(b)

House 3: Apr_26
good section #26
slice 45 of 64

Fig. 1(c)

Fig. 2(a)

Read live high-frequency i(t) and v(t) streams    S 101

Event detected?    S 102

Begin recording event, including left-settle period    S 103a

S 103b

Event settled within $t_{evmax}$ according to strict criteria?

NO

S 103c    S 103

Final $n_{settle\_mincyc}$ or greater samples within relaxed criteria?

NO

S 103d    YES

End event at end of detected right settle period.

$t_{event} < t_{evmax}$

S 103e    YES

Find latest plateau-like region within $t_{evmax}$ of the start of the event and use that as the right-settle period, such that $t_{event} = t_{evmax}$

S 103f

Find latest plateau-like region within $t_{evmax}$ of the start of the event and use that as the right-settle period, such that $t_{event} < t_{evmax}$

Extraction of full feature set    S 104

Classification of device by ML algorithm (RF, DeepNet, XGBoost, distance measure vs. previous classifications or ensemble of the above)    S 105

Fig. 2(b)(i)

S 106

**Classifier probability above high threshold? (e.g: >0.9?)** — YES → single event passed

NO

S 107

Run time series segmentation algorithm to find plateaus (e.g. change point detection or GMM clustering)

See drawing F for example

S 108

**> 2 Plateaus found?** — NO → single event passed

Pass classifier output and selected features for event/candidate event sets to probabilistic model

YES

S 109

Create an event for each isolated subtransient with step-size above the threshold, using the plateau regions as the left/right settle regions as appropriate.

S 110

**> 3 Plateaus found?** — NO → S 111

Extract full feature set for all isolated events and classify using by ML algorithm (RF, DeepNet, XGBoost or ensemble of them)

Candidate single event and two events passed

YES

S 112

Create further candidate events set by isolating an event for each permutation of sub-transients. For example when 3 subtransients are found, isolate an event for subtransient pairs (1,2),(1,3),(2,3)

Classify all events from all candidate event sets, using ML algorithm(s) as previously

S 113

S 114

**Classifier probability for any special devices of interest above high threshold? (e.g. $p_{microwave}$ for event from subtransient pair (1,3) >0.9?)** — NO → Candidate single event multiple candidate event sets passed

YES

S 115

Remove candidate event sets that do not include the event featuring special device of interest

One or more candidate event set passed

# Fig. 2(b)(ii)

Fig. 3

Fig. 4(a)

Fig. 4(b)

Fig. 5(a)

Fig. 5(b)

raw event powerscape (cube root)

powerscape with b.g. removed (cube root)

cycle

sample

Fig. 6(a)

Fig. 6(b)

S601 | Assemble collection of labelled current or power cycles samples, ensuring an approximately equal representation of different classes present

S602 | Take the magnitude of 1D fourier transform of each power cycle. Each sample's absolute spectrum is stored as a column of the $n \times m$ dimensional matrix **P**

S603 | Perform NMF on **P** to obtain matrix of non-negative factors **(B)** and their time series activations **(W)**

S604 | Basis vectors **B** can now be used to extract activations $W_{ev}$ for each event in the training sample and augmented to its feature vector $X_{ev}$ or alternatively used as a replacement for $X_{ev}$. The device classifier (e.g. random forest) can be trained on this $X$

# Fig. 6(c)

| Feature type | Distinct Power Level | Distinct IV | Appears on Multiple Phases (US homes) | Appears on Multiple Phases (commercial building) | Distinct Transients | Distinct PQ Onset | Simple Rectangle | Regular Combs or Irregular Chopping | Distinct Duration | Significant P decay | Multiple Levels | |
|---|---|---|---|---|---|---|---|---|---|---|---|---|
| Addressed with | Step Size | Event Based System | | | | | | HMM | | | | |
| Helpfulness / Ease of Use | High / Easy | High / Easy | High / Easy | | Medium / OK | Medium / OK | Medium / OK | Medium / OK | Medium / OK | Lower / Tricky | Lower / Tricky | DISAGGREGATION METHOD |
| Coffee Machine | No | No | Single | Single | No | No | No | Irregular Chopping | No | Don't Know | No | choppy pattern |
| Kettle | Somewhat | No | Single | Single | No | No | Yes | No | Short | No | No | power level and simple rectangle |
| Breadmaker | No | No | Single | Single | No | No | No | Interesting Chopping | Probably Long | Don't Know | No | choppy pattern, long periods |
| Hairdryer | No | No | Single | Single | No | No | No | No | No | No | Very Often | multiple levels? |
| Halogen Lights | No | No | Single | Single | Somewhat | No | No | No | No | Yes | No | very large onset decay, low-ish power |
| Dryer | Somewhat | Partially | Multiple | Single | Somewhat | Somewhat | No | Somewhat | Very Long | No | Yes | |
| Microwave | No | Yes | Single | Single | Yes | No | No | only defrost | No | Yes | No | distinct IV, distinct onset |
| Fluorescent Lights | No | Yes | Single | Single | Somewhat | No | No | No | No | No | No | distinct IV |
| Fridge | No | Yes | Varies | Single | Somewhat | Yes | No | No | No | No | No | distinct IV, distinct onset |
| Air Conditioner | No | Yes | Multiple | Multiple | Somewhat | Somewhat | No | Interesting Chopping | Very Long | Yes | Quite often | interesting IV, long term pattern chopping |
| Dishwasher | Somewhat | Partially | Multiple | Single | Somewhat | Somewhat | No | Somewhat | Very Long | No | Yes | long cycle with a few small transients |
| Washing Machine | Somewhat | Partially | Multiple | Single | Somewhat | Yes | No | Somewhat | Very Long | No | Yes | long cycle with many large transients |

Fig. 6(d)

For n in range (2,6):
↙ Perform GMM clustering on 1D real power (P) data
↙ For each model, record the Akaike Information Criteria (AIC) score of this models fit to the P data

S 701

Take the clustering with the lowest (best) AIC score

S 702

Assign all P values to the Gaussian cluster within the selected model which was most likely to have generated it

S 703

For each cluster in the model, select the longest time-contiguous region of P points assigned to it and remove any other points from the assignment
(there often will only be one time-contiguous region)

Each remaining time-contiguous region is a
"candidate plateau"

S 704

# Fig. 7(a)

For each candidate plateau, calculate the mean and variance of the P points assigned to it — S 705

For each pair of time-adjacent candidate plateaus a and b, check whether the means $\mu_a$, $\mu_b$ are within $2\sigma_a$ or $2\sigma_b$ of each other.

If not, then accept this plateau as a plateau.

If so, then merge the candidate plateaus by combining the sets of points $\{P_a, P_b\}$ into a new cluster with mean $\mu_{(a,b)}$ and standard deviation $\sigma_{(a,b)}$. This is a new candidate plateau; and the same overlapping variance check should be performed until no more time-adjacent plateaus overlap with it. Once this is the case, accept the resultant set of P points as a plateau. — S 706

More than 2 plateaus?

# Fig. 7(b)

## Microwave full switch-on event with sub-events labelled (real power)

## Kettle switch-on Event Occuring During Microwave switch-on (real power per cycle) (actual data gathered from Green Running trial deployment)

## Kettle switch-on Event Occuring During Microwave switch-on (Instantaneous Power Draw) (actual data gathered from Green Running trial deployment)

*«delta-cyc»*$_1$: plateau ii-i
*«delta-cyc»*$_2$: plateau iii-ii
*«delta-cyc»*$_3$: plateau iv-iii

# Fig. 8

Fig. 9

Update total probability of $hs_{t,j}$ by adding the probability of reaching $hs_{t,j}$ via $hs_{t-1,i}$

This is the product of:
- The total probability of $hs_{t-1,i}$
- d's probability in the classifier output
- The appropriate prior (either switch-on prior or active state change prior)
- Survival probability of all active devices from $hs_{t-1,i}$ other than d

S 907

Update most likely (Viterbi) path to $hs_{t,j}$ as the most likely path to $hs_{t-1,i}$ plus the step from $hs_{t-1,i} \rightarrow hs_{t,j}$ and save its probability

YES

does path history to $hs_{t,j}$ via $hs_{t-1,i}$ have higher probability than any other path to $hs_{t,j}$? (or is it the only path so far?)

S 908

NO

Do not update most likely path to this state

Obtain marginal probabilities of newly created house states by taking their total probabilities and normalising to to sum to one

S 909

For each device d, obtain the total probability of it being in each of it's allowed states (e.g. [on, off] or [on, rest, off]) at t:
- for each of its states S, sum the marginal probability of each new house state containing d in state S (e.g. 'on') at t.
- normalising the total probabilities of each state of d so that they sum to one. This gives the probabilities of each state of d at t.

S 910

# Fig. 9 (Continued)

| For each device class | Load repository of labelled appliance power consumption data<br>• frequently low-frequency; 1Hz or lower is sufficient<br>• pre-processed with annotations of which discrete states<br>the appliance was in throughout time | S 1001 |

| For each active state<br>transition<br><br>S 1003 | Extract empirical distribution of appliance state duration prior<br>to active state transition | S 1002 |
| | Fit suitable parametric distribution to empirical distribution | Learning transition<br>probabilities |
| | Save parametric distribution and its cumulative distribution<br>function, which will be used to calculate state transition /<br>survival probabilities at test time. | S 1004 |

| S 1005 | Record total number of active state transitions per unit time for<br>this device class | Learning active<br>state transition priors |
| S 1006 | Record the total number of switch-on events per unit time for<br>this device class | Learning switch-on<br>priors |
| S 1007 | assemble all power steps observed for each state of interest | Learning the emission<br>probabilities |
| S 1008 | fit a suitable parametric distribution to the empirical power<br>step data. | |

# Fig. 10

UC: User characteristics
DC: Device characteristics
$P_t$ : Observed power at time t
a: activity mode a
d: device d

DC$^d$

DS$_1^d$ → DS$_2^d$ → ..... → DS$_i^d$

$\widehat{y_1}, T_1$ Psettle1

$\widehat{y_1}, T_2$ Psettle2

$\widehat{y_1}, T_i$ Psettle_i

inputs from high frequency event detection & classification pipeline

e.g.: $P_{settle1}$ = 1,210W

$T_1$ = 12:00:53

$\widehat{y_1}$ = {Toaster: 0.7,
Hob: 0.2,
Kettle: 0.05,
Heater: 0.03
Oven: 0.02
Microwave: 0.0}

e.g.: $P_{settle2}$ = -1,185W

$T_1$ = 12:02:36

$\widehat{y_2}$ = {Toaster: 0.55,
Heater: 0.20,
Hob: 0.15,
Kettle: 0.05,
Oven: 0.05
Microwave: 0.0}

Fig. 11

Fig. 12(a)

Fig. 12(b)

High Frequency Data
Acquisition and Signal
Conditioning | 1kHz - 5MHz

High frequency stream v(t), i(t)

Simple
Event Detection

High frequency stream v(t), i(t)

Event Analysis and
possible separation
into subevents

Separated events v(t), i(t)

Event feature
extraction

ë: Event feature vector

Classification of
Event

t: time of event observation
ë: feature vector
p(c` ë): probability distribution of
device classes

Probalistic
Model:
Classification of
p(t) time-series

Prior statistics for correlation
between devices

Prior statistics for device
duration and power level

Device and House
State Tracker

↙ Most likely state history of
stepping devices
↙ State probability distribution
for each device

Disaggregation
Result to front
end app

# Fig. 13

**EP 3 290 869 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013145778 A

- US 9250101 B